(19) **Europäisches Patentamt / European Patent Office / Office européen des brevets**

(11) **EP 3 076 512 B1**

(12) **EUROPEAN PATENT SPECIFICATION**

(45) Date of publication and mention
of the grant of the patent:
**11.04.2018 Bulletin 2018/15**

(21) Application number: **15754499.0**

(22) Date of filing: **20.02.2015**

(51) Int Cl.:
*H02J 3/00* (2006.01)　　　*G06Q 50/10* (2012.01)
*G08G 1/00* (2006.01)　　　*G08G 1/09* (2006.01)
*G08G 1/13* (2006.01)　　　*H02J 7/00* (2006.01)
*B60L 3/12* (2006.01)　　　*G08G 1/01* (2006.01)
*G07C 5/00* (2006.01)　　　*H02J 3/32* (2006.01)
*B60L 11/18* (2006.01)　　　*G06F 17/50* (2006.01)
*G06N 5/04* (2006.01)

(86) International application number:
**PCT/JP2015/054780**

(87) International publication number:
**WO 2015/129575 (03.09.2015 Gazette 2015/35)**

(54) **ELECTRICITY-DEMAND PREDICTION DEVICE, ELECTRICITY SUPPLY SYSTEM, ELECTRICITY-DEMAND PREDICTION METHOD, AND PROGRAM**

ELEKTRIZITÄTSNACHFRAGEVORHERSAGEVORRICHTUNG, ELEKTRIZITÄTSBEREITSTELLUNGSSYSTEM, ELEKTRIZITÄTSNACHFRAGEVORHERSAGEVERFAHREN UND PROGRAMM

DISPOSITIF DE PRÉDICTION DE DEMANDE D'ÉLECTRICITÉ, SYSTÈME D'ALIMENTATION D'ÉLECTRICITÉ, PROCÉDÉ DE PRÉDICTION DE DEMANDE D'ÉLECTRICITÉ ET PROGRAMME

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.02.2014 JP 2014038748**

(43) Date of publication of application:
**05.10.2016 Bulletin 2016/40**

(73) Proprietor: **Mitsubishi Heavy Industries, Ltd.**
**Tokyo 108-8215 (JP)**

(72) Inventors:
• **YAMASHINA Yusuke**
**Tokyo 108-8215 (JP)**
• **KOYANAGI Yoko**
**Tokyo 108-8215 (JP)**

• **SAITO Mayumi**
**Tokyo 108-8215 (JP)**
• **SUGIMOTO Kiichi**
**Tokyo 108-8215 (JP)**
• **YANO Shinya**
**Tokyo 108-8215 (JP)**

(74) Representative: **Henkel, Breuer & Partner**
**Patentanwälte**
**Maximiliansplatz 21**
**80333 München (DE)**

(56) References cited:
**EP-A1- 2 465 721**　　　**EP-A1- 2 562 514**
**WO-A1-2011/132583**　　**WO-A1-2012/023564**
**WO-A1-2013/024484**　　**JP-A- 2012 115 066**
**US-A1- 2012 083 932**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to an electricity-demand prediction device, an electricity supply system, an electricity-demand prediction method, and a program that predict the amount of electricity demand at a charging facility.

Background Art

In recent years, an electric car having a battery mounted therein or hybrid cars have become widespread, and accordingly, electricity demand at charging facilities has increased. Accordingly, a distribution planning technique for controlling a total amount of electrical energy to be generated according to a prediction result of electricity demand and an amount of electrical energy to be supplied according to areas and time periods has been used.

In order to predict electricity demand, generally, a technique of performing prediction by constructing a prediction model using a statistical method based on previous electricity demand records, time information, calendar information indicating days of the week, holidays or the like has been used, for example (for example, see Patent Literature 1).

Furthermore, in a case where electricity demand is predicted in a specific area, a technique of statistically analyzing group behavior trends in a specific area and modeling the group behavior trends has been used.

Citation List

Patent Literature

[PTL 1] Japanese Unexamined Patent Application Publication No. 2012-113546

EP 2 465 721 A1 discloses a system for predicting energy need of a plurality of electric-energy vehicles across a determined management area.

WO 2013/024484 A1 discloses methods and systems for predicting demand for battery services in an electric vehicle network.

US 2012/083932 A1 discloses a system for managing electrical power requirements between at least two power grids including a number of automotive vehicles each of which has an electric motor which propels the vehicle at least partly during its operation.

EP 2 562 514 A1 discloses an information provision device and an information provision method suppressing charge amount shortage in a predetermined area.

Summary of Invention

Technical Problem

However, for example, in a case where group behavior trends in a specific area are statistically analyzed, in order to construct models for reproducing features of all group behavior trends in the specific area with high accuracy, it is necessary to provide a large amount of record data (instructional data). On the other hand, since the number of probe cars (vehicles having a function of acquiring detailed traveling data) may be limited, it may not be possible to acquire a considerable amount of record data. Thus, it is difficult to reproduce group behavior trends in a specific area with high accuracy.

In order to solve the above-mentioned problems, an object of the invention is to provide an electricity-demand prediction device, an electricity supply system, an electricity-demand prediction method, and a program capable of performing electricity demand prediction with high accuracy based on limited record data.

Solution to Problem

According to the present invention, there is provided an electricity-demand prediction device as outlined in independent claim 1, an electricity supply system as outlined in claim 5, an electricity-demand prediction method as outlined in independent claim 6, and a program as outlined in independent claim 7. Advantageous developments are defined in the dependent claims.

According to a first aspect of the invention, there is provided an electricity-demand prediction device (1) including: an area feature value prediction unit (114) that receives an input of measurement data (D1) relating to a vehicle and predicts, according to divided areas (A1, A2, and so on) which are divided into plural pieces, an area feature value indicating a feature relating to a vehicle that belongs to a divided area; an individual model acquisition unit (112) that acquires, using the area feature value as an input and using electricity demand for a specific vehicle (201, 202, and so on) at a specific charging facility (301, 302, and so on) as an output, an individual model (M1, M2, and so on) of each specific vehicle; and a demand prediction computation unit (113) that inputs the predicted area feature value to the individual model to calculate a predicted value of electricity demand for the specific vehicle corresponding to the individual model at the specific charging facility.

According to such an electricity-demand prediction device, since predicted values of area feature values derived from a group behavior trend with high periodic regularity are used as factors of individual models indicating individual behavior trends, it is possible to perform prediction with high accuracy going forward relatively far into the future.

According to a second aspect of the invention, in the above-described electricity-demand prediction device, the area feature value prediction unit includes at least one of a vehicle density in the divided area, an average speed of all vehicles in the divided area, or an average charging rate of batteries of all the vehicles that belong to the divided area, as the area feature value.

According to such an electricity-demand prediction device, as a group behavior trend, a vehicle density, a vehicle average speed or an average charging rate having high periodic regularity is used as a predicted value, and thus, it is possible to perform electricity demand prediction based on the predicted value with high accuracy.

According to a third aspect of the invention, in the above-described electricity-demand prediction device, the individual model acquisition unit generates an individual model indicating a correlation between a record value of factor information indicating a decision-making factor for charging of a specific vehicle at a specific charging facility and a record value indicating electricity demand for the specific vehicle at the specific charging facility, with respect to the specific vehicle, based on measurement data relating to the vehicle.

According to such an electricity-demand prediction device, an individual model is generated based on a record value of factor information indicating a decision-making factor in charging for each user of an electric car. Accordingly, it is possible to use an individual model in which a user's decision is correctly reflected.

Furthermore, according to a fourth aspect of the invention, in the above-described electricity-demand prediction device, the individual model acquisition unit acquires an individual model indicating a correlation between a distance between a current position of the specific vehicle and the specific charging facility and electricity demand at the specific charging facility.

According to such an electricity-demand prediction device, since a correlation between a distance between a vehicle and a charging facility and electricity demand in the charging facility is indicated as an individual model in which an individual behavior trend is reflected, it is possible to reduce efforts for generating the individual model.

According to a fifth aspect of the invention, there is provided an electricity supply system including: the above-described electricity-demand prediction device; and an electricity supply management device that adjusts an electricity supply for each charging facility according to a prediction result of the electricity-demand prediction device.

According to such an electricity supply system, since the electricity supply management device adjusts an electricity supply for each charging facility according to a prediction result of the electricity-demand prediction device with high accuracy, it is possible to perform an electricity supply service management with high efficiency.

Furthermore, according to a sixth aspect of the invention, there is provided an electricity-demand prediction method including the steps of: receiving an input of measurement data relating to a vehicle and predicting, according to divided areas which are divided into plural pieces, an area feature value indicating a feature relating to a vehicle that belongs to a divided area; acquiring, using the area feature value as an input and using electricity demand for a specific vehicle at a specific charging facility as an output, an individual model of each specific vehicle; and inputting the predicted area feature value to the individual model to calculate a predicted value of electricity demand for the specific vehicle corresponding to the individual model at the specific charging facility.

According to such an electricity-demand prediction method, since predicted values of area feature values derived from a group behavior trend with high periodic regularity are used as factors of individual models indicating individual behavior trends, it is possible to perform prediction with high accuracy going forward relatively far into the future.

According to a seventh aspect, there is provided a program that causes a computer of an electricity-demand prediction device to function as: means for receiving an input of measurement data relating to a vehicle and predicting, according to divided areas which are divided into plural pieces, an area feature value indicating a feature relating to a vehicle that belongs to a divided area; means for acquiring, using the area feature value as an input and using electricity demand for a specific vehicle at a specific charging facility as an output, an individual model of each specific vehicle; and means for inputting the predicted area feature value to the individual model to calculate a predicted value of electricity demand for the specific vehicle corresponding to the individual model at the specific charging facility.

According to such a program, since predicted values of area feature values derived from a group behavior trend with high periodic regularity are used as factors of individual models indicating individual behavior trends, it is possible to perform prediction with high accuracy going forward relatively far into the future.

Advantageous Effects of Invention

According to the above-described electricity-demand prediction device, the electricity supply system, the electricity-demand prediction method, and the program, it is possible to perform electricity demand prediction with high accuracy based on limited record data.

Brief Description of Drawings

Fig. 1 is a diagram illustrating an outline of an electricity supply system according to a first embodiment.
Fig. 2 is a diagram illustrating a functional configuration of an electricity-demand prediction device according to the first embodiment.
Fig. 3 is a diagram illustrating details of vehicle probe data stored in a data accumulation unit according to the first embodiment.
Fig. 4 is a first diagram illustrating a function of an individual model acquisition unit according to the first embodiment.
Fig. 5 is a second diagram illustrating a function of the individual model acquisition unit according to the first embodiment.
Fig. 6 is a third diagram illustrating a function of the individual model acquisition unit according to the first embodiment.
Fig. 7 is a fourth diagram illustrating a function of the individual model acquisition unit according to the first embodiment.
Fig. 8 is a diagram illustrating an example of individual models according to the first embodiment.
Fig. 9 is a first diagram illustrating a function of an area feature value prediction unit according to the first embodiment.
Fig. 10 is a second diagram illustrating a function of the area feature value prediction unit according to the first embodiment.
Fig. 11 is a third diagram illustrating a function of the area feature value prediction unit according to the first embodiment.
Fig. 12 is a flowchart illustrating a processing flow of a demand prediction computation unit according to the first embodiment.
Fig. 13 is a first diagram illustrating a function of the demand prediction computation unit according to the first embodiment.
Fig. 14 is a second diagram illustrating a function of the demand prediction computation unit according to the first embodiment.
Fig. 15 is a third diagram illustrating a function of the demand prediction computation unit according to the first embodiment.
Fig. 16 is a diagram illustrating a function of an area feature value prediction unit according to a modification example of the first embodiment.
Fig. 17 is a diagram illustrating a function of an individual model acquisition unit according to a modification example of the first embodiment.
Fig. 18 is a diagram illustrating a function of a demand prediction computation unit according to a second embodiment.

Description of Embodiments

<First embodiment>

Hereinafter, an electricity supply system according to a first embodiment will be described.
The electricity supply system according to the first embodiment predicts electricity demand at each of charging facilities (in this embodiment, a "usage rate" of each charging facility) through two stages of a step of predicting feature values according to predetermined divided areas in a specific area (for example, in a city), and a step of inputting the predicted feature values to individual models in which decision-making features of individual users are reflected.

(Overall configuration)

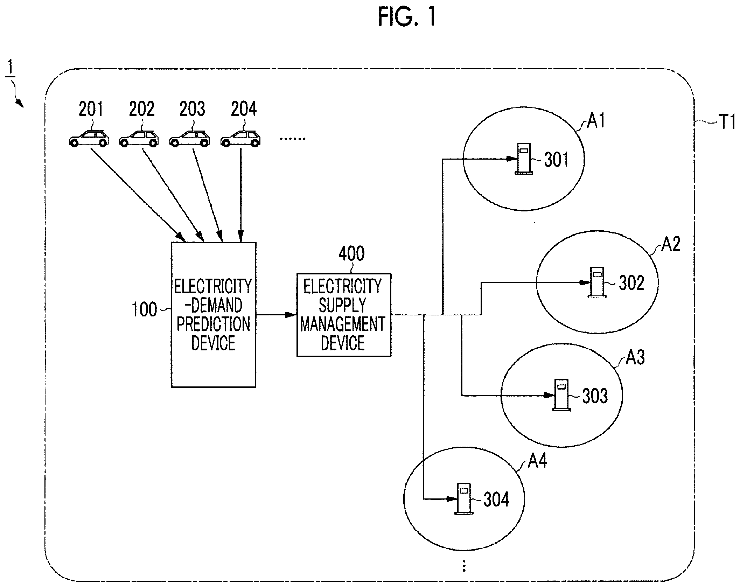

Fig. 1 is a diagram illustrating an outline of the electricity supply system according to the first embodiment.
An electricity supply system 1 according to the first embodiment includes an electricity-demand prediction device 100, plural probe cars 201, 202, and so on, plural charging facilities 301, 302, and so on, and an electricity supply management device 400.
The electricity supply system 1 provides electricity supply service for an electric car in a specific area (for example, in a city T1). Specifically, the electricity supply system 1 provides electricity for battery charging to an electric car that travels in the city T1 through the charging facilities 301, 302, and so on provided in respective locations of the city T1.

The electricity-demand prediction device 100 receives inputs of plural pieces of vehicle probe data D1 (which will be described later) from the respective probe cars 201, 202, and so on, and performs prediction of electricity demand (usage rates according to time periods) in each of the charging facilities 301, 302, and so on based on the vehicle probe data D1.

The probe cars 201, 202, and so on are electric cars used by specific users among residents who belong to the city T1. Each of the probe cars 201, 202, and so on is provided with an exclusive on-board device (not shown), and is able to record a traveling state of each of the probe cars 201, 202, and so on in a predetermined time interval. For example, each of the probe cars 201, 202, and so on is able to record operating state information indicating whether each of the probe cars 201, 202, and so on is being operated, vehicle position information (for example, latitude and longitude information obtained using a global positioning system (GPS)) for specifying each position of the probe cars 201, 202, and so on, and state of charge (SOC) information indicating a rate [%] (remaining capacity) of a battery mounted therein, as traveling states of each probe car.

Contents of the traveling states capable of being acquired by the probe cars 201, 202, and so on are not limited to the above-described information, and traveling distance information, speed and acceleration information acquired through speed and acceleration sensors mounted therein, or the like may be recorded. In addition, a variety of information during stop and during charging of the probe cars 201, 202, and so on may be recorded. Further, the probe cars 201, 202, and so on are not limited to a configuration in which respective traveling states are acquired "in a predetermined time interval", and may have a configuration in which respective traveling states are recorded when a specific event which is arbitrarily determined occurs. Specifically, for example, the probe cars 201, 202, and so on may record, at every predetermined traveling distance, or in every predetermined vehicle state change (change from a traveling state to a vehicle stop state, ON and OFF switching of a main power source, and ON and OFF switching of a headlight), respective traveling states of the probe cars 201, 202, and so on at time points corresponding thereto.

The charging facilities 301, 302, and so on are installed at respective locations in the city T1. Users of electric cars perform charging of the electric cars in the charging facilities 301, 302, and so on installed at the respective locations. In this embodiment, as shown in Fig. 1, the charging facilities 301, 302, and so on are installed at respective locations of predetermined divided areas A1, A2, A3, and so on that belong to the city T1.

The supplied electricity management device 400 makes a distribution plan so that electricity necessary for charging can be supplied from each of the charging facilities 301, 302, and so on, based on and in reflection of a prediction result of electricity demand (usage rates according to time periods with respect to each of the charging facilities 301, 302, and so on).

(Functional configuration of electricity-demand prediction device)

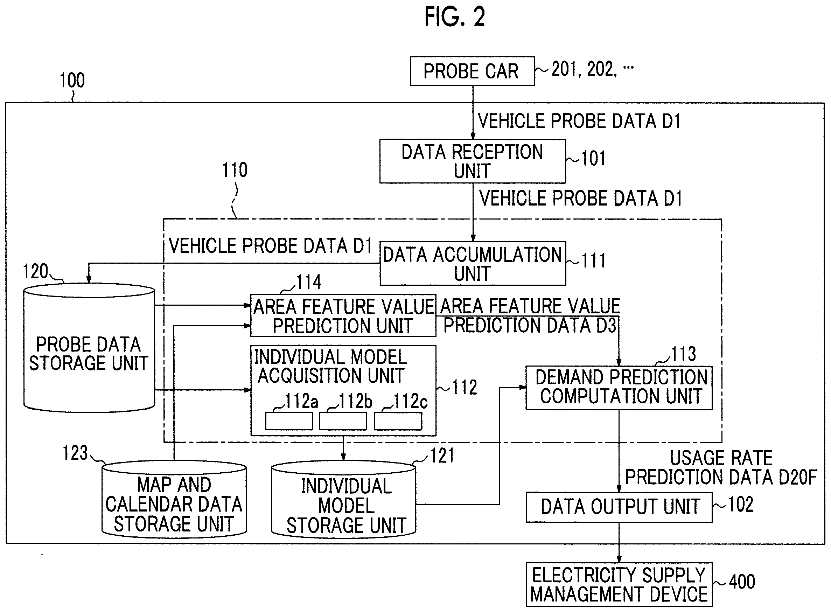

Fig. 2 is a diagram illustrating a functional configuration of the electricity-demand prediction device according to the first embodiment.

As shown in Fig. 2, the electricity-demand prediction device 100 according to this embodiment includes a data reception unit 101, a data output unit 102, a central processing unit (CPU) 110, a probe data storage unit 120, an individual model storage unit 121, and a map and calendar data storage unit 123.

The data reception unit 101 is a communication module that receives an input of the vehicle probe data D1 from each of the probe cars 201, 202, and so on. Here, the on-vehicle device of each of the probe cars 201, 202, and so on automatically outputs the acquired vehicle probe data D1 to the data reception unit 101 through predetermined communication means. Instead of a configuration in which each on-vehicle device automatically transmits the vehicle probe data D1 to the data reception unit 101, a user (manager) of the electricity supply system 1 may manually perform a process of transmitting the vehicle probe data D1 to the data reception unit 101 from each on-vehicle device.

The data output unit 102 is a communication module that outputs usage rate prediction data D20F obtained through a calculation process (which will be described later) of the CPU 110 to the electricity supply management device 400.

The CPU 110 is a versatile CPU that performs the entire processes of the electricity-demand prediction device 100. The CPU 110 is operated according to an exclusive program read in a storage area to realize functions as a data accumulation unit 111, an individual model acquisition unit 112, a demand prediction computation unit 113, and an area feature value prediction unit 114. Details of the respective functions will be described later.

The probe data storage unit 120 is a storage area in which the acquired vehicle probe data D1 is stored through a process of the CPU 110 (data accumulation unit 111 (which will be described later)).

The individual model storage unit 121 is a storage area in which individual models of the probe cars 201, 202, and so on, generated by the CPU 110 (the individual model acquisition unit 112 (which will be described later)) are respectively stored.

Further, the map and calendar data storage unit 123 stores map data D4 in which a road network, blocks (ranges of divided areas A1, A2, and so on), and positions of the charging facilities 301, 302, and the like in the city T1 are recorded and calendar data D5 in which a calendar including weekdays, holidays (festive days), and the like is recorded.

The above-described probe data storage unit 120, the individual model storage unit 121, and the map and calendar data storage unit 123 may have a configuration in which storage is performed in a single storage device.

As described above, the CPU 110 according to this embodiment includes functions as the data accumulation unit 111, the individual model acquisition unit 112, the demand prediction computation unit 113, and the area feature value prediction unit 114.

The data accumulation unit 111 successively stores the vehicle probe data D1 input through the data reception unit 101 in the probe data storage unit 120. The content of the vehicle probe data D1 stored by the data accumulation unit 111 will be described later.

The individual model acquisition unit 112 performs a process of generating individual models M1, M2, and so on corresponding to the probe cars 201, 202, and so on (users P1, P2, and so on), based on past vehicle probe data D1 which is accumulated in the probe data storage unit 120. Here, the "individual models" are simulation models in which features (particularly, decision-making features in charging) in usage of the probe cars 201, 202, and so on, of the respective users, are reflected. The individual model acquisition unit 112 stores the generated individual models M1, M2, and so on in the individual model storage unit 121.

Further, as shown in Fig. 2, the individual model acquisition unit 112 generates individual models based on processes of a factor information extraction unit 112a, an electricity demand information extraction unit 112b, and a model construction unit 112c provided therein. Specific processing contents of the factor information extraction unit 112a, the electricity demand information extraction unit 112b, and the model construction unit 112c will be described later.

The area feature value prediction unit 114 acquires area feature value prediction data D3F which is a predicted value of an area feature value (which will be described later) of each of the divided areas A1, A2, and so on based on past vehicle probe data D1 which is accumulated in the probe data storage unit 120, and the map data D4 and the calendar data D5 stored in the map and calendar data storage unit 123.

The demand prediction computation unit 113 calculates predicted values (usage rate prediction data D20F) of usage rates according to time periods in each of the charging facilities 301, 302, and so on, based on the individual models M1, M2, and so on stored in the individual model storage unit 121 and area feature value prediction data D3F acquired by the area feature value prediction unit 114.

(Function of data accumulation unit)

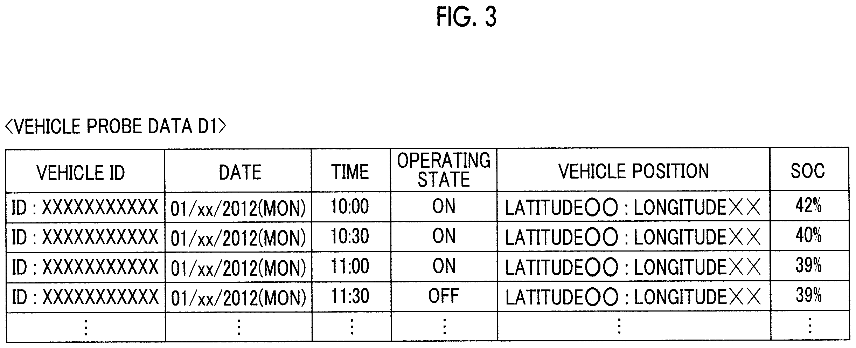

Fig. 3 is a diagram illustrating details of vehicle probe data stored by the data accumulation unit according to the first embodiment.

As described above, the data accumulation unit 111 successively stores and accumulates the vehicle probe data D1 acquired in the respective probe cars 201, 202, and so on in the probe data storage unit 120. For example, the data accumulation unit 111 stores the vehicle probe data D1 in the form of a configuration as shown in Fig. 3. Specifically, as shown in Fig. 3, in the probe data storage unit 120, a vehicle ID for identifying each of the probe cars 201, 202, and so on, a date and a time period, operating state information indicating whether each vehicle is being operated (whether the vehicles are being driven), latitude and longitude information for specifying a position of the vehicle, and SOC information indicating a charging rate (remaining capacity) of a battery mounted therein are recorded. The data accumulation unit 111 extracts the operating state information, the latitude and longitude information, and the SOC information, for example, every 30 minutes to store the results in the probe data storage unit 120.

In the probe data storage unit 120, for example, one or more pieces of vehicle probe data D1 previously acquired by each of the probe cars 201, 202, and so on are stored. It is preferable that plural sets of a variety of information over past several months to several years are stored and accumulated as the vehicle probe data D1, for example.

Further, a configuration of the vehicle probe data D1 stored in the probe data storage unit 120 is not limited to the configuration shown in Fig. 3, and a configuration in which other items (for example, traveling distance information, speed and acceleration information, or the like) relating to traveling of the probe cars 201, 202, and so on is recorded may be used. Further, a configuration in which charging facility IDs to be acquired in charging are stored and it is determined which one of the charging facilities 301, 302, and so on charging is performed through may be used.

(Function of individual model acquisition unit)

The factor information extraction unit 112a of the individual model acquisition unit 112 extracts factor record data D10 which is a record value of factor information with reference to the vehicle probe data D1 (Fig. 3) stored in the probe data storage unit 120. Here, the "factor information" refers to a variety of information which may be a decision-making factor for performing charging in the respective charging facilities 301, 302, and so on by users P1, P2, and so on of the probe cars 201, 202, and so on. Specifically, the factor information extraction unit 112a extracts time period activation area data D12, time period SOC data D13, or the like, which will be described below, from the vehicle probe data D1, as record values of factor information (factor record data D10).

(Time period activity area data)

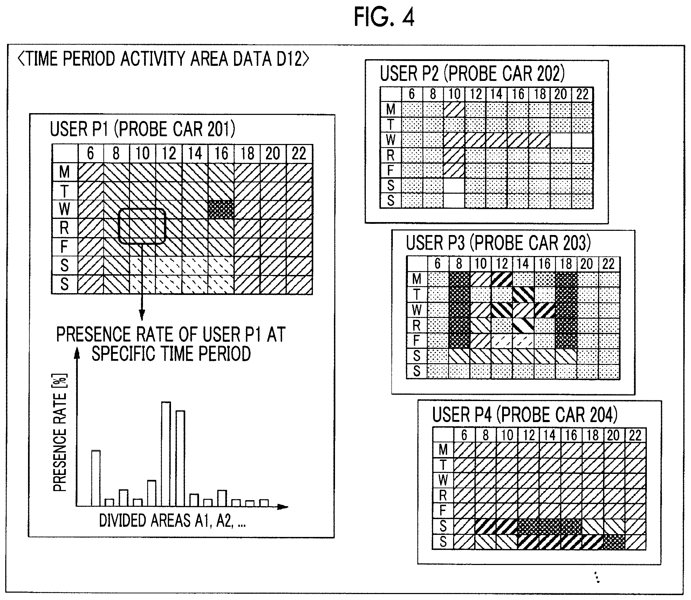

Fig. 4 is a first diagram illustrating a function of the individual model acquisition unit according to the first embodiment.

The factor information extraction unit 112a extracts the time period action area data D12 which belongs to the factor record data D10 from the vehicle probe data D1 stored in the probe data storage unit 120. Here, as shown in Fig. 4, the time period activity area data D12 is information dividedly indicating areas (divided areas A1, A2, and so on) to which the users (probe cars 201, 202, and so on) belong according to time periods for one week. Specifically, the factor information extraction unit 112a obtains the time period activity area data D12 in which rates at which the users P1, P2, and so on (probe cars 201, 202, and so on) are present in each of the divided areas A1 and A2 on each day of the week and in each time period are specified, with reference to latitude and longitude information on the day of the week and in the time period (Fig. 3), from past vehicle probe data D1 which is accumulated in the probe data storage unit 120 (see Fig. 4) .

(SOC data according to time periods)

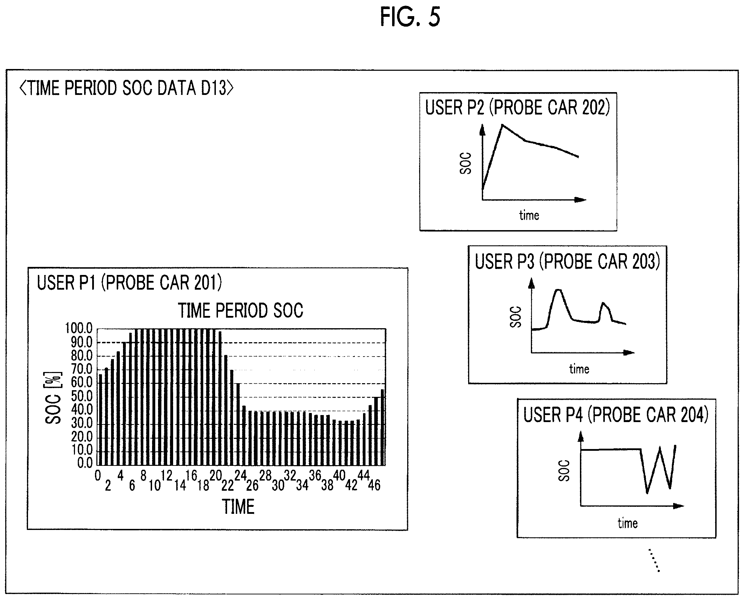

Fig. 5 is a second diagram illustrating a function of the individual model acquisition unit according to the first embodiment.

The factor information extraction unit 112a further extracts time period SOC data D13 or the like which belongs to the factor record data D10 from the vehicle probe data D1 stored in the probe data storage unit 120. Here, the time period SOC data D13 is information obtained by recording SOCs [%]of users (probe cars 201, 202, and so on) according to time periods through a predetermined sensor, as shown in Fig. 5. Thus, as described later, the individual model acquisition unit 112 may acquire an individual behavior trend of each user (decision-making feature in charging) indicating the level of reduction of an SOC at which charging is performed.

Although not shown in Fig. 5, the factor information extraction unit 112a may extract charging speed information D14 or the like, calculated from an SOC increase per unit time with reference to SOCs according to time periods in the vehicle probe data D1. Thus, it is possible to recognize whether the users P1, P2, and so on prefer a facility suitable for fast charging among the charging facilities 301, 302, and so on, for example.

As described above, the individual model acquisition unit 112 according to this embodiment extracts the factor record data D10 (time period activity area data D12 and time period SOC data D13) which are past record values of plural pieces of factor information ("vehicle positions" and "SOCs"). In addition, the factor information extraction unit 112a may extract a record value of other factor information (for example, whether each of the charging facilities 301, 302, and so on to be used is suitable for fast charging, the type of additional service provided in each of the charging facilities 301, 302, and so on, or the like) in which a causal relationship with decision-making factors in charging for the users P1, P2, and so on is recognized.

(Usage rate record data)

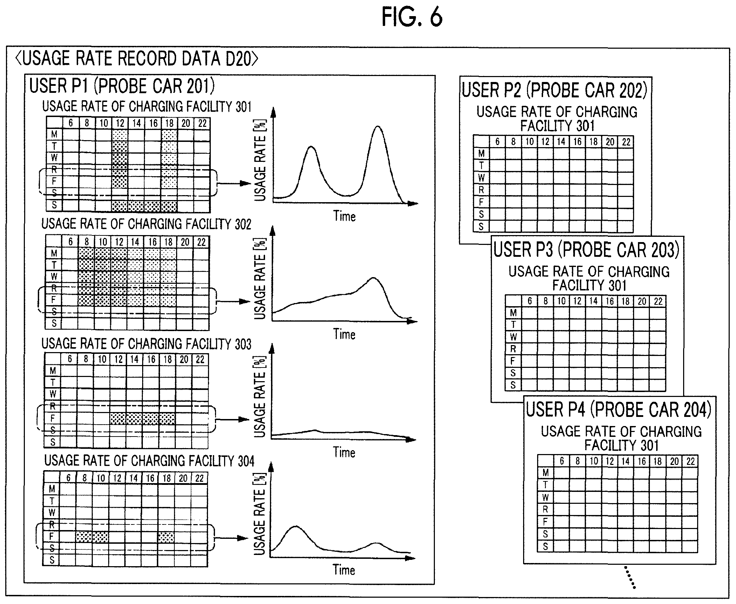

Fig. 6 is a third diagram illustrating a function of the individual model acquisition unit according to the first embodiment.

Next, the individual model acquisition unit 112 extracts a record value (electricity demand record data) of electricity demand at each of the charging facilities 301, 302, and so on, with reference to past vehicle probe data D1 (Fig. 3) which is stored in the probe data storage unit 120. In this embodiment, specifically, the electricity demand information extraction unit 112b of the individual model acquisition unit 112 extracts usage rate record data D20 indicating a record value of a usage rate in each time period as the record value of the electricity demand at each of the charging facilities 301, 302, and so on.

Specifically, the usage rate record data D20 is statistic data indicating frequencies (usage rates) at which the users P1, P2, and so on use the charging facilities 301, 302, and so on according to days of the week and time periods (see Fig. 6). The electricity demand information extraction unit 112b extracts information about whether each of the charging facilities 301, 302, and so on is being used by each of the users P1, P2, and so on each day of the week and in each time period based on vehicle position information or time period SOC information recorded in past vehicle probe data D1 (Fig. 3), and calculates its frequency in each time period as the usage rate. With such a configuration, the electricity demand information extraction unit 112b is able to obtain the usage rate record data D20 which is a past record value of information (that is, a usage rate of each of the charging facilities 301, 302, and so on according to time periods) which is a prediction target.

For example, according to the usage rate record data D20 (Fig. 6) of the charging facility 301 with respect to the user P1, it can be shown that the frequency (rate) at which the user P1 uses the charging facility 301 around 6 p.m. over the entire weekdays is high.

(Construction of individual models)

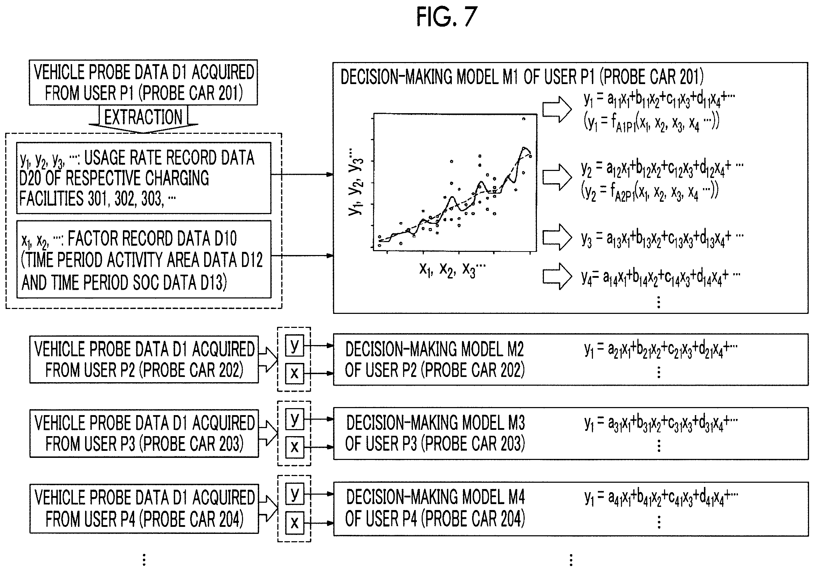

Fig. 7 is a fourth diagram illustrating a function of the individual model acquisition unit according to the first embodiment.

Next, a function of a model construction unit 112c that generates individual models of the users P1, P2, and so on based on the factor record data D10 and the usage rate record data D20 described above will be described with reference to Fig. 7.

The model construction unit 112c receives inputs factor record data D10 and usage rate record data D20 extracted from the vehicle probe data D1 of each of the probe cars 201, 202, and so on, accumulated in the probe data storage unit 120, and generates individual models M1, M2, and so on indicating correlations between the factor record data D10 and the usage rate record data D20 according to the users P1, P2, and so on (that is, according to the probe cars 201, 202, and so on).

Specifically, the model construction unit 112c selects "vehicle positions" and "SOCs" which are parameters of respective pieces of the time period activity area data D12 (Fig. 4) and the time period SOC data D13 (Fig. 5) relating to the user P1 (probe car 201) as factors $x_1$ and $x_2$ of the individual model M1. The model construction unit 112c may set other factor information (for example, whether the charging facilities 301, 302, and so on are suitable for fast charging, the type of additional service, or the like) which becomes decision-making factors for charging of the users P1, P2, and so on as factors x3, x4, and so on.

On the other hand, the model construction unit 112c sets respective record values of usage rates of the charging facilities 301, 302, and so on extracted as the usage rate record data D20 (Fig. 6) relating to the probe car 201 as responses $y_1$, $y_2$, and so on. Here, the responses $y_1$, $y_2$, and so on are responses with respect to inputs of the factors $x_1$, $x_2$, and so on in the individual model M1.

The model construction unit 112c generates the individual model M1 indicating the correlations of the responses $y_1$, $y_2$, and so on with respect to the factors $x_1$, $x_2$, and so on. The generated individual model M1 corresponds to the user P1 (probe car 201). As shown in Fig. 7, for example, the correlations between the rate (usage rate) $y_1$ at which the user P1 uses the charging facility 301 and the factors $x_1$, $x_2$, and so on are expressed as Expression (1).

$$y_1 = a_{11}x_1 + b_{11}x_2 + c_{11}x_3 + d_{11}x_4 + \cdots \qquad \cdot\cdot\cdot\ (1)$$

Here, coefficients $a_{11}$, $b_{11}$, and so on relating to the factors $x_1$, $x_2$, and so on in Expression (1) represent factor loads of the factors $x_1$, $x_2$, and so on. That is, a factor having a larger factor road has a stronger correlation with the response $y_1$, while a factor having a smaller factor load has a weaker correlation with the response $y_1$.

For example, the model construction unit 112c is able to calculate a factor load $a_{11}$ indicating the strength of the correlation between the vehicle position (factor $x_1$) and the usage rate (response $y_1$) of the charging facility 301 based on the time period activity area data D12 and the usage rate record data D20.

Here, in a case where the value of the factor load $a_{11}$ is large, this means that a usage rate (response $y_1$) at which the user p1 uses the charging facility 301 is in a strong causal relationship with a time period vehicle position (factor $x_1$) of the user P1 (probe car 201). That is, this shows a feature of the user P1 indicating that "the user P1 selects a charging facility in serious consideration of whether the charging facility is close to a current position".

Similarly, the model construction unit 112c may calculate a factor load b11 indicating the strength of the correlation between the SOC (factor x2) and the usage rate (response $y_1$) of the charging facility 301 based on the time period SOC data D13 and the usage rate record data D20.

Here, for example, in a case where a value of the factor load b11 is small, this means that the correlation between the usage rate (response $y_1$) at which the user P1 uses the charging facility 301 and the SOC of the user P1 (probe car 201) in each time period is weak. That is, this shows a feature of the user P1 indicating that "the user P1 performs charging using the charging facility 301 regardless of the remaining capacity of the battery at a current time point".

In this way, the individual model acquisition unit 112 according to this embodiment derives a bundle of expressions indicating the correlations between known factors $x_1$, $x_2$, and so on (factor record data D10) and known responses $y_1$, $y_2$, and so on (usage rate record data D20) acquired in the past, and generates the individual model M1 in which a decision-making feature in charging relating to the user P1 is reflected).

As a method of deriving expressions (for example, the above-described Expression (1)) indicating respective correlations between known factors $x_1$, $x_2$, and so on and known responses $y_1$, $y_2$, and so on, for example, a simulation model construction method based on a support vector machine (SVM) or a neural network (NN), or the like which is a known model construction method may be used. More simply, a general least-squares method may be used. Furthermore, Expression (1) indicating the correlations is only an example, and alternatively, a more complicated expression (secondary function, exponential function, logarithmic function, or the like) indicating correlations may be used.

As shown in Fig. 7, the model construction unit 112c performs the same processes with respect to the users P2, P3, and so on (probe cars 202, 203, and so on), to thereby generate the individual models M2, M3, and so on in which features of the respective users are reflected. Then, the model construction unit 112c stores the generated individual models M1, M2, and so on in the individual model storage unit 121.

In the following description, a function indicating the correlations between the response $y_1$ relating to the charging facility 301 installed in the divided area A1 and the factors $x_1$, $x_2$, and so on relating to the users P1 (probe car 201) is expressed as Expression (2) (see Fig. 7).

$$y_1 = f_{A1P1}(x_1, x_2, x_3, x_4 \cdots) \qquad \cdots (2)$$

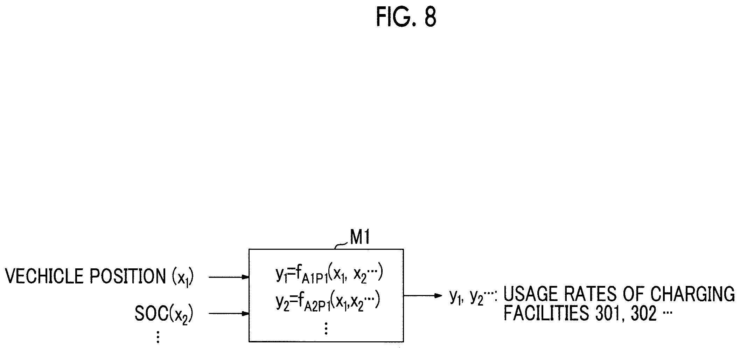

Fig. 8 is a diagram illustrating an example of an individual model according to the first embodiment.

The individual model M1 generated through the above-described processes in the individual model acquisition unit 112 is reflected in the decision-making feature in charging relating to the user P1. That is, in a case where the vehicle position of the user P1 (probe car 201) is "$x_1$" and the SOC is "$x_2$" at a current time point, the individual model M1 may assign rates (usage rates) $y_1$, $y_2$, and so on at which the user P1 uses the charging facilities 301, 302, and so on.

Similarly, the individual models M2, M3, and so on reflect the decision-making features in charging for the users P2, P3, and so on.

(Function of area feature value prediction unit)

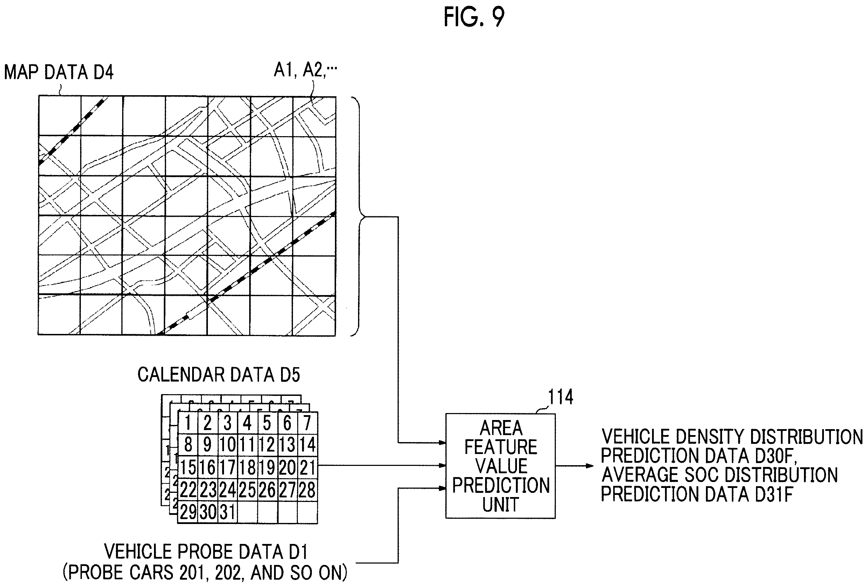

Fig. 9 is a first diagram illustrating a function of the area feature value prediction unit according to the first embodiment.

The area feature value prediction unit 114 according to this embodiment receives an input of the vehicle probe data D1 accumulated in the probe data storage unit 120 as measurement data relating to a vehicle, and predicts an area feature value of each of the divided areas A1, A2, and so on which are divided into plural pieces. Here, the "area feature value" represents a feature relating to a vehicle that belongs to each of the divided area A1, A2, and so on. In this embodiment, an example in which the "area feature value" specifically includes an "area vehicle density" and an "area average SOC" (area average charging rate) is shown, but the "area feature value" may include other values (for example, "area average vehicle speed", "area average electricity efficiency" (average of electricity consumption necessary for traveling a target area), or the like).

As shown in Fig. 9, first, the area feature value prediction unit 114 receives inputs of the map data D4 and the calendar data D5 which are stored in advance in the map and calendar data storage unit 123, and the vehicle probe data D1 of each of the probe cars 201, 202, and so on stored and accumulated in the probe data storage unit 120. Then, the area feature value prediction unit 114 calculates "vehicle density distribution prediction data D30F" indicating future prediction of the "area vehicle density" of each of the divided areas A1, A2, and so on, and "average SOC distribution prediction data D31F" indicating future prediction of the "area average SOC", based on the variety of data. Both the "vehicle density distribution prediction data D30F" and the "average SOC distribution prediction data D31F" correspond to the "area feature value prediction data D3F" indicating a predicted value of the area feature value of each of the divided areas A1, A2, and so on.

In the map data D4, a road network, blocks (range of the divided areas A1, A2, and so on), positions of the charging facilities 301 and 302, or the like in the city T1 are recorded. On the other hand, in the calendar data D5, a calendar including weekdays, holidays (festive days), and the like from the past to the future is stored.

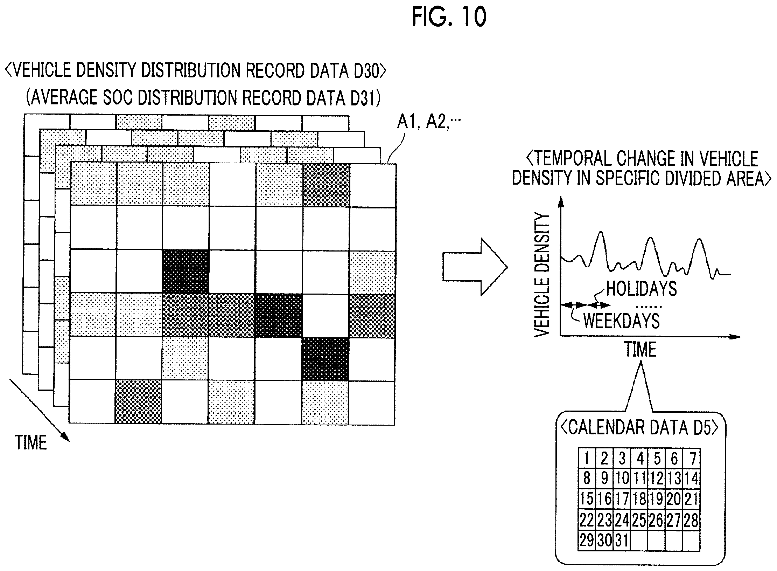

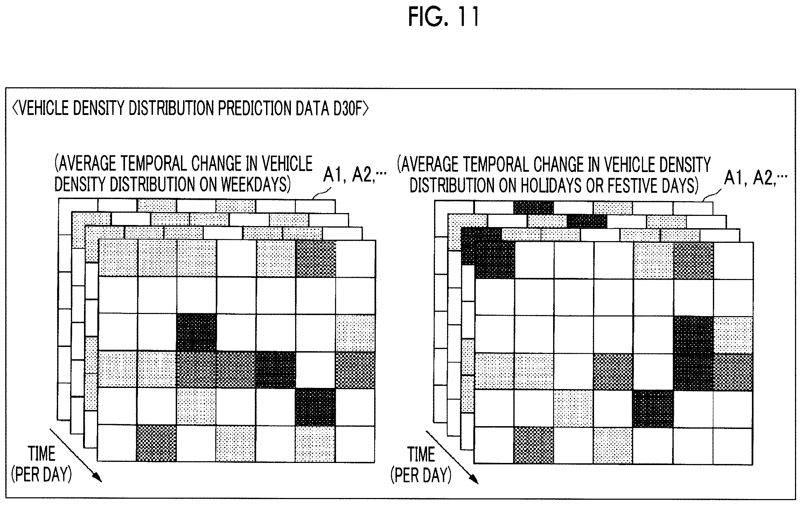

Figs. 10 and 11 are second and third diagrams illustrating functions of the area feature value prediction unit according to the first embodiment.

The area feature value prediction unit 114 specifies which one of the divided areas A1, A2, and so on each of the probe cars 201, 202, and so on belongs to according to time periods, with reference to date and time information of the vehicle probe data D1 (Fig. 3), and so on, vehicle position information, or the like of the plural probe cars 201, 202. Then, the area feature value prediction unit 114 calculates the number of the probe cars 201, 202, and so on which are present in each of the divided areas A1, A2, and so on according to time periods. The area feature value prediction unit 114 divides the number of the probe cars 201, 202, and so on by each divided area of the divided areas A1, A2, and so on, and approximates the result as a value indicating a vehicle density (area vehicle density) of all the vehicles which are present at each of the divided areas A1, A2, and so on to obtain the vehicle density distribution record data D30.

In Fig. 10, a magnitude relation of the vehicle densities of the respective divided areas A1, A2, and so on calculated by the area feature value prediction unit 114 is represented by color strengths of the respective divided areas A1, A2, and so on (see left side in Fig. 10).

Further, the area feature value prediction unit 114 extracts SOCs of each of the probe cars 201, 202, and so on that belongs to each of the divided areas A1, A2, and so on according to time periods with reference to SOC information of the vehicle probe data D1 (Fig. 3). Further, the area feature value prediction unit 114 calculates SOC distribution record data D31 indicating average SOCs (area average SOCs) of electric cars which are present in each of the divided areas A1, A2, and so on according to time periods using the same method as described above (see left side in Fig. 10).

The area feature value prediction unit 114 performs a process of applying the calendar (weekdays, or holidays and festive days) of the calendar information D5 to a record value (left side in Fig. 10) of temporal change in an area vehicle density or an area average SOC in each of the divided areas A1, A2, and so on to extract periodic regularity (see right side in Fig. 10). For example, the area feature value prediction unit 114 extracts a record value of temporal change in an area vehicle density (area average SOC) on "weekdays" and a record value of temporal change in an area vehicle density (area average SOC) on "holidays or festive days", and calculates an average temporal change on "weekdays", and "holidays or festive days". Thus, the area feature value prediction unit 114 obtains an average temporal change in the obtained area vehicle density on "weekdays" and "holidays or festive days" (area average SOC).

In this embodiment, the area feature value prediction unit 114 uses a past average temporal change in the obtained vehicle density on "weekdays" and "holidays or festive days" as a future predicted value (vehicle density distribution prediction data D30F) of the vehicle density in each of the divided areas A1, A2, and so on (see Fig. 11). Specifically, the area feature value prediction unit 114 specifies which one of "weekdays" and "holidays or festive days" a future date corresponds to based on the calendar D5, and sets the result as the future predicted value of the area vehicle density in each of the divided areas A1, A2, and so on with reference to the average temporal changes (the left side and the right side in Fig. 11) corresponding to both of "weekdays" and "holidays or festive days".

Similarly, the area feature value prediction unit 114 uses a past average temporal change of the area average SOC on "weekdays" and "holidays or festive days" as the predicted value (average SOC distribution prediction data D31F) of the average SOC in each of the divided areas A1, A2, and so on.

In the above-described example, a configuration in which the area feature value prediction unit 114 classifies the average temporal changes of the area feature values (area vehicle density and area average SOC) according to "weekdays" or "holidays or festive days" and predicts the area feature values based on which one of "weekdays" and "holidays or festive days" a future data corresponds to is described. However, in other embodiments, the invention is not limited to this configuration, and classification items may increase. For example, the area feature value prediction unit 114 may acquire weather forecast information capable of being received from an external device, and may predict an area feature value according to indicating whether future predicted weather is "fine" or "rainy".

In this case, the area feature value prediction unit 114 includes a weather information acquisition unit capable of acquiring weather record information indicating actual weather according to time periods and weather forecast information indicating future weather prediction. Furthermore, the area feature value prediction unit 114 performs a process of applying the weather record information ("fine" or "rainy" at a specific time period) acquired by the weather information acquisition unit to the record value (left side in Fig. 10) of the temporal change in the area vehicle density or the area average SOC to extract regularity between the temporal change in the area vehicle density or the area average SOC and the weather.

With such a configuration, the area feature value prediction unit 114 can predict an area vehicle density and an area average SOC based on weather forecast information (future prediction indicating information whether the weather is "fine" or "rainy") which is separately acquired, in addition to the information indicating whether the calendar is "weekdays" or "holidays or festive days".

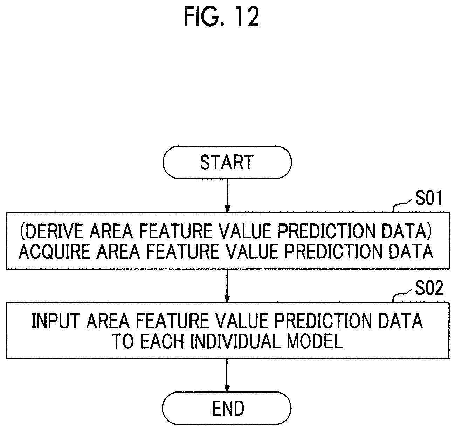

Fig. 12 is a flowchart illustrating a processing flow of the demand prediction computation unit according to the first embodiment.

The processing flow of the demand prediction computation unit 113 according to the first embodiment will be sequentially described with reference to Fig. 12 and the like.

As shown in Fig. 12, the demand prediction computation unit 113 performs a process of two stages of a step (step S01) of acquiring the area feature value prediction data D3 calculated by the area feature value prediction unit 114 and a step (step S02) of inputting the area feature value prediction data D3 to each of the individual models M1 and M2 generated by the individual model acquisition unit 112.

In step S01, first, the area feature value prediction unit 114 executes the processes described using Figs. 9 to 11 to calculate the area feature value prediction data D3 (vehicle density distribution prediction data D30F and average SOC distribution prediction data D31F). The demand prediction computation unit 113 receives an input of the calculated area feature value prediction data D3 from the area feature value prediction unit 114.

Here, as described below, the vehicle density distribution prediction data D30F and the average SOC distribution prediction data D31F acquired by the area feature value prediction unit 114 respectively correspond to a factor $x_1$ (vehicle position) and a factor $x_2$ (SOC) of the individual models M1, M2, and so on. That is, in step S02, the demand prediction computation unit 113 inputs a predicted value of a vehicle position and a predicted value of an SOC which are respectively indicated by the acquired vehicle density distribution prediction data D30F and the average SOC distribution prediction data D31F to the factors $x_1$ and $x_2$ of the individual models M1, M2, and so on (see Fig. 8).

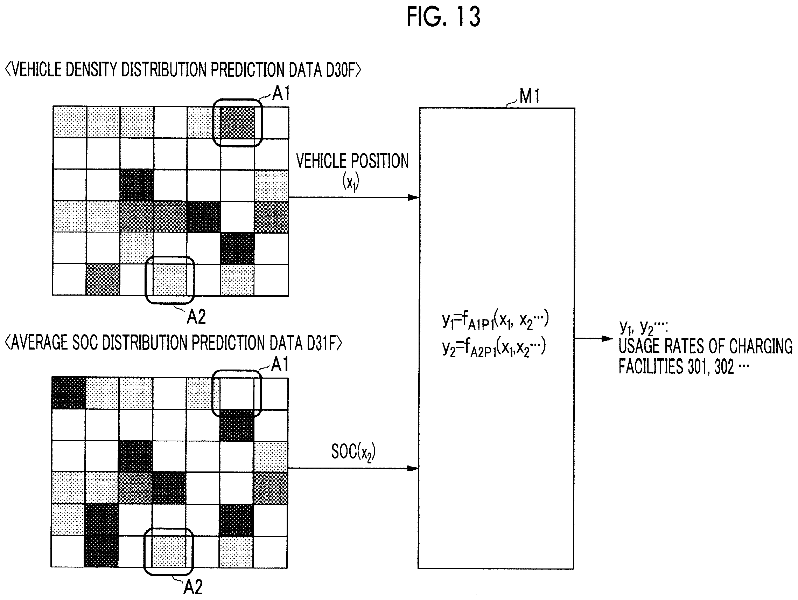

Fig. 13 is a first diagram illustrating a process of the demand prediction computation unit according to the first embodiment.

Hereinafter, a specific process of the area feature value prediction unit 114 in step S02 (Fig. 12) will be described with reference to Fig. 13.

As shown in Fig. 13, the demand prediction computation unit 113 performs weighting depending on a rate at which a user is present in each of the divided areas A1, A2, and so on with respect to the vehicle position (factor $x_1$) of the individual model M1. Specifically, a vehicle density in each of the divided areas A1, A2, and so on indicated by the vehicle density distribution prediction data D30F is predicted as a rate at which the user P1 is present in each of the divided areas A1, A2, and so on. Here, it is considered that, as the vehicle density in each of the divided areas A1, A2, and so on becomes higher, a rate at which the user P1 is present in each of the divided areas A1, A2, and so on becomes higher in proportion.

The demand prediction computation unit 113 performs weighting with respect to the plural responses $y_1$ obtained by respectively substituting the factor $x_1$ in the divided areas A1, A2, and so on using values depending on the rates at which the user is present in the respective divided areas A1, A2, and so on, and sums up the results. For example, it is assumed that a predicted value of a rate at which the user P1 (probe car 201) is present in the divided area A1 at a certain future time point is 30% and a predicted value of a rate at which the user P1 is present in the divided area A2 is 5% in the obtained vehicle density distribution prediction data D30F. In this case, the demand prediction computation unit 113 performs weighting corresponding to 30% and 5% with respect to both of a response (fA1P1(A1)) obtained by substituting "A1" in the factor $x_1$ and a response (fA1P1(A2)) obtained by substituting "A2" in the factor $x_1$, and sums up the results, to thereby calculate a predicted value $y_1$ of a usage rate of the charging facility 301. Specifically, the predicted value $y_1$ of the usage rate of the charging facility 301 is calculated as $y_1 = fA1P1 (A1) \times 30\% + fA1P1 (A2) \times 5\% + \dots$.

Similarly, the demand prediction computation unit 113 calculates plural responses $y_1$ obtained by respectively substituting, in the factor $x_2$, predicted values of SOCs in the divided areas A1, A2, and so on in the average SOC distribution prediction data D31F. For example, it is assumed that an average SOC in the divided area A1 is 80% and an average SOC in the divided area A2 is 25% in the obtained average SOC distribution prediction data D31F. In this case, in a case where "A1" is substituted in the factor $x_1$, the demand prediction computation unit 113 substitutes an SOC of 80% in the factor $x_2$, to thereby calculate fA1P1 (A1, 80%). Further, in a case where "A2" is substituted in the factor $x_1$, the demand prediction computation unit 113 substitutes an SOC of 25% in the factor $x_2$, to thereby calculate fA1P1 (A2, 25%). Thus, the demand prediction computation unit 113 calculates usage rate prediction data D20f indicating prediction results of usage rates of the charging facilities 301, 302, and so on with respect to the user P1.

In this way, the demand prediction computation unit 113 according to this embodiment uses predicted values of area feature values (area vehicle density and area average SOC) for easily detecting behavior trends of all resident groups in the city T1 as an input (factor information) of the individual model M1 corresponding to the user P1 in step S02 (Fig. 11). Thus, the demand prediction computation unit 113 can employ group behavior trends in the city T1 capable of being predicted with relatively high accuracy as a part of the factors of the individual models, and thus, it is possible to obtain a prediction result with high accuracy going forward far into the future.

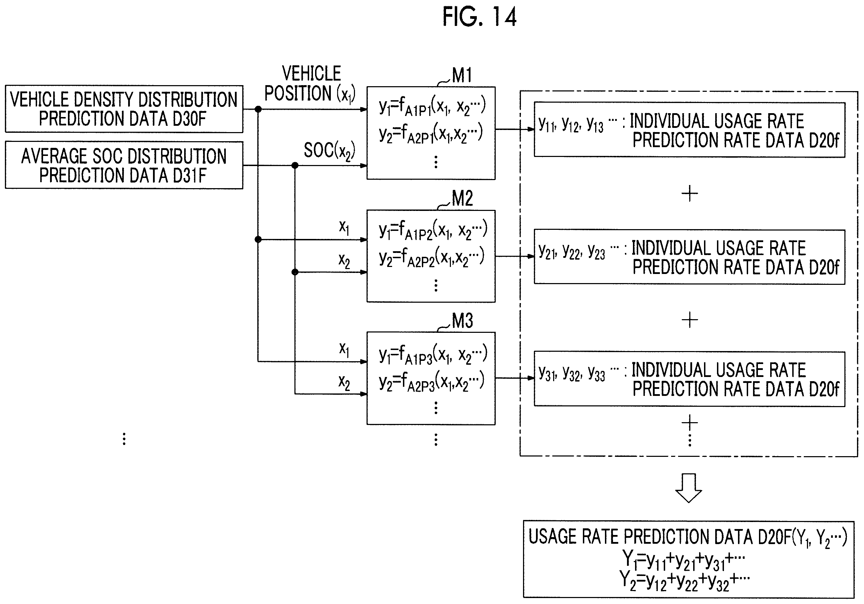

Fig. 14 is a second diagram illustrating a process of the demand prediction computation unit according to the first embodiment.

As shown in Fig. 14, the demand prediction computation unit 113 similarly substitutes the vehicle density distribution prediction data D30F and the average SOC distribution prediction data D31F in the individual models M2, M3, and so on corresponding to the other users P2, P3, and so on, to thereby calculate usage rate prediction data D20f for each of the users P2, P3, and so on.

If the individual usage rate prediction data D20f for the entirety of the users P1, P2, and so on is calculated, the demand prediction computation unit 113 totals the entire individual usage rate prediction data D20f for each of the charging facilities 301, 302, and so on, and calculates a predicted value of a usage rate of each of the charging facilities 301, 302, and so on in each time period. For example, in a case where it is predicted that rates at which the respective users P1, P2, and so on use the charging facility 301 at a certain time period are $y_{11}$, $y_{21}$, and so on, the demand prediction computation unit 113 may calculate a predicted value $Y_1$ of a usage rate in the time period of the charging facility 301 as $Y_1 = y_{11} + y_{21} + Y_{31} + \dots$. The demand prediction computation unit 113 similarly calculates predicted values $Y_2$, $Y_3$, and so on of usage rates of the other charging facilities 302, 303, and so on at the same time period (see Fig. 14).

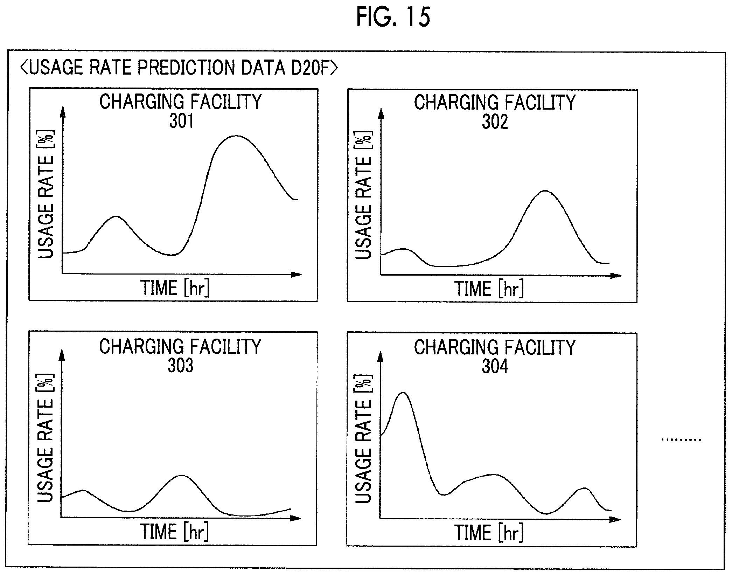

Fig. 15 is a third diagram illustrating a function of the demand prediction computation unit according to the first embodiment.

The demand prediction computation unit 113 acquires the usage rate prediction data D20F in which change in a predicted value of a usage rate in the future (for example, within 24 hours from a current time point) for each of the charging facilities 301, 302, and so on is predicted, through the above-described processes (see Fig. 14) (see Fig. 15).

The demand prediction computation unit 113 outputs the usage rate prediction data D20F (electricity demand prediction data) for each of the charging facilities 301, 302, and so on acquired in this way to the electricity supply management device 400 through the data output unit 102. The electricity supply management device 400 makes a distribution plan with respect to each of the charging facilities 301, 302, and so on, based on and in reflection of a prediction result (usage rate prediction data D20F) of electricity demand for each of the charging facilities 301, 302, and so on. For example, in a time periodat which it is predicted that the usage rate of the charging facility 301 is high, the electricity supply management device 400 makes a distribution plan so that electricity supply suitable for its electricity demand is performed. Thus, the electricity supply system 1 can appropriately generate and supply necessary electricity depending on the electricity demand in each of the charging facilities 301, 302, and so on which is predicted in advance, and thus, it is possible to efficiently perform an electricity supply service management.

(Effects)

According to the electricity supply system 1 according to the above-described first embodiment, the electricity-demand prediction device 100 first executes the step (step S01 (Fig. 12)) of predicting feature values according to divided areas (area feature values) in which a group behavior trend in a specific area (city T1) are reflected. Furthermore, the electricity-demand prediction device 100 executes the step (step S02 (Fig. 12)) of inputting the predicted area feature values to the individual models in which a decision-making feature in charging for each user is reflected. The electricity-demand prediction device 100 according to this embodiment predicts a usage rate of each charging facility through two-stage processes of "prediction based on a group behavior trend" and "prediction based on individual behavior trends".

Since a charging time period or a charging location varies according to a traveling situation or preference of each individual user, it is difficult to predict electricity demand with high accuracy. However, the electricity supply system 1 according to the above-described first embodiment reflects a lifestyle, a sense of values, or the like of each user in a simulation analysis using the process in the prediction (step S02) based on an individual behavior trend, to thereby make it possible to perform electricity demand prediction based on user's decision with high accuracy. Further, the electricity-demand prediction device 100 approximates groups of plural individual models in which each user's decision making is reflected as all resident groups in a city to predict electricity demand. Accordingly, it is possible to construct a simulation model with high accuracy with a small amount of data compared with the amount of record data necessary for directly modeling behavior trends of all resident groups.

Furthermore, the demand prediction computation unit 113 employs an area feature value capable of being predicted with high accuracy as the group behavior trend, as at least a part of the factors to be input to the individual models, in the prediction (step S01) based on a group behavior trend. For example, in this embodiment, as the "area feature value", an area vehicle density and an area average SOC are used as prediction targets. All of the area vehicle density, the area average SOC, and the like have features with high periodic regularity in a predetermined time interval (for example, everyday or every week), as behavior trends of all resident groups in a city. That is, with respect to the area vehicle density or the like, a record value acquired in the past may be reproduced with high accuracy at each future time period. Accordingly, by inputting predicted values derived from a group behavior trend with high regularity as factors of individual models, it is possible to perform prediction with high accuracy going forward relatively far into the future (for example, for one week).

In electricity demand prediction in the related art, there is a possibility that if information which is in a causal relationship with demand is not used, it is not possible to appropriately perform prediction, and it is difficult to find a factor having a strong causal relationship. However, according to this embodiment, factors that lead to a charging behavior are dividedly considered in "prediction based on a group behavior trend" and "prediction based on an individual behavior trend", and thus, it is possible to easily determine a causal relationship between a factor to be predicted and data capable of being measured. Thus, it is easy to perform demand management using demand and response, or the like.

As described above, according to the electricity supply system 1 according to the first embodiment, it is possible to perform electricity demand prediction with high accuracy.

(Modification example of the first embodiment)

In the above-described embodiment, a configuration in which the area feature value prediction unit 114 acquires area feature value prediction data D3F indicating predicted values of area feature values at each of the divided areas A1, A2, and so on, based on the vehicle probe data D1 which is accumulated in the past, is described. However, the area feature value prediction unit 114 according to another embodiment may acquire the area feature value prediction data D3F based on information observed for determination of all behavior trends in the city T1, instead of the past vehicle probe data D1. Specifically, the area feature value prediction unit 114 according to other embodiments includes a sectional traffic amount information acquisition unit that acquires sectional traffic record data observed using a traffic counter or the like in a road network in the divided areas A1, A2, and so on, and extracts regularity of change in an area vehicle density derived from the acquired sectional traffic amount record data, to thereby predict the area vehicle density.

Here, in the first embodiment, in a case where the number of probe cars 201, 202, and so on is limited, since a total amount of data of the vehicle probe data D1 is small, there is a case where a group behavior trend cannot be reproduced with high accuracy. However, in the case of this modification example, since prediction of area feature values is performed based on measurement data (sectional traffic or the like) acquired for determination of the group behavior trend, it is possible to further enhance the accuracy of prediction.

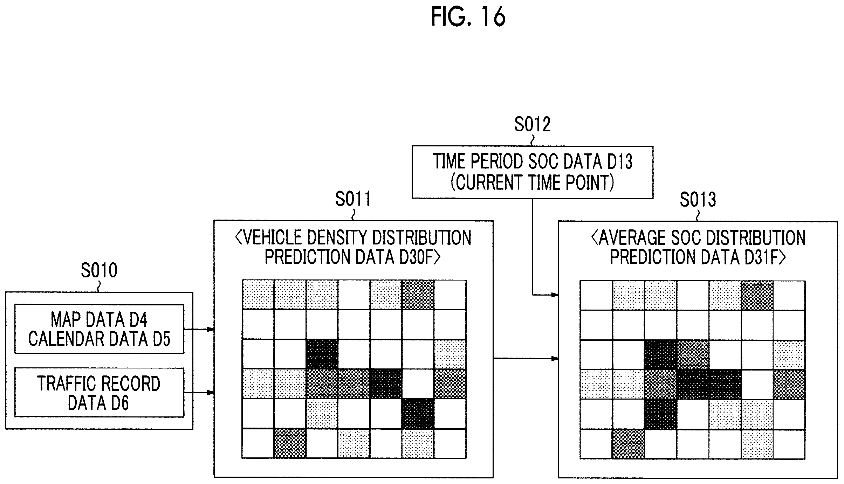

Fig. 16 is a diagram illustrating a function of the area feature value prediction unit according to the modification example of the first embodiment.

In this modification example, prediction is performed by dividing the "prediction based on a group behavior trend" in step S01 (Fig. 12) into "prediction of traffic situations" depending on situations of all vehicles including gasoline cars, and "prediction of SOC distribution" depending on situations of electric cars.

Specifically, first, the sectional traffic information acquisition unit acquires record data (traffic record data D6) of a sectional traffic acquired through the traffic counter or the like. Furthermore, the area feature value prediction unit 114 receives inputs of the map data D4, the calendar data D5, and the traffic record data D6 stored in the map and calendar data storage unit 123 (step S010), and acquires the vehicle density distribution prediction data D30F (step S011). This process is configured by the same process as in processing contents described using Figs. 9 to 11. However, since the acquired vehicle density distribution prediction data D30F is prediction data based on all behavior trends of the vehicles including electric cars, gasoline car, and the like, the accuracy of prediction becomes higher than that of the first embodiment.

On the other hand, the area feature value prediction unit 114 acquires the time period SOC data D13 (Fig. 5) capable of being extracted from the vehicle probe data D1 acquired in each of the probe cars 201, 202, and so on (step S012). The time period SOC data D13 represents record value of SOCs at a current time point of the probe cars 201, 202, and so on.

The area feature value prediction unit 114 receives inputs of the vehicle density distribution prediction data D30F acquired in step S011 and the time period SOC data D13 indicating record values of SOCs at a current time point in each of the probe cars 201, 202, and so on to acquire the average SOC distribution prediction data D31F. Specifically, the area feature value prediction unit 114 calculates a remaining capacity (SOC) of an electric car which is traveling along a predicted traffic flow based on a traffic flow of all vehicles predicted from the vehicle density distribution prediction data D30F and an SOC of each electric car at a current time point. Thus, the area feature value prediction unit 114 acquires the average SOC distribution prediction data D31F. Since the acquired average SOC distribution prediction data D31F is prediction data based on behavior trends of all the vehicles in addition to electric cars, similar to the vehicle density distribution prediction data D30F, the accuracy of prediction becomes high.

The area feature value prediction unit 114 inputs the predicted values (vehicle density distribution prediction data D30F and average SOC distribution prediction data D31F) of the area feature values respectively calculated in Fig. 16 to the individual models M1, M2, and so on which are generated in advance, and calculates predicted values of usage rates of the charging facilities 301, 302, and so on (see Figs. 13 to 15) .

As described above, according to the electricity-demand prediction device 100 according to the above-described modification example, it is possible to enhance the accuracy of prediction by predicting behavior trends of all resident groups in the city T1 based on statistic data (sectional traffic or the like) with respect to all the vehicles that belong to the city T1.

In the above-described example, the area feature value prediction unit 114 may use person trip data, land usage data, or traffic demand data such as a questionnaire, in addition to the measurement value of the sectional traffic acquired through the traffic counter. In addition, the area feature value prediction unit 114 may predict various area feature values using a predetermined traffic flow simulator based on the variety of data.

Furthermore, the area feature value prediction unit 114 may apply the information such as the amount of a measured traffic to the traffic flow simulator to reproduce entire traffic flows according to time periods in the city T1, to thereby acquire predicted values of more detailed area feature values (for example, an area average speed or an area average acceleration indicating an average speed or an average acceleration of all the vehicles in a specific divided area, or the like). In this case, the area feature value prediction unit 114 may predict the average SOC distribution prediction data D31F in consideration of vehicle travel information such as a speed or acceleration in addition to the predicted traffic flow. With such a configuration, since the amount of information used for prediction increases, it is possible to further enhance the accuracy of prediction based on a group behavior trend.

(Modification example of individual model)

Further, the configurations of the individual models M1, M2, and so on are not limited to the above-described configurations (Figs. 8 and 14), and may be changed as follows, for example.

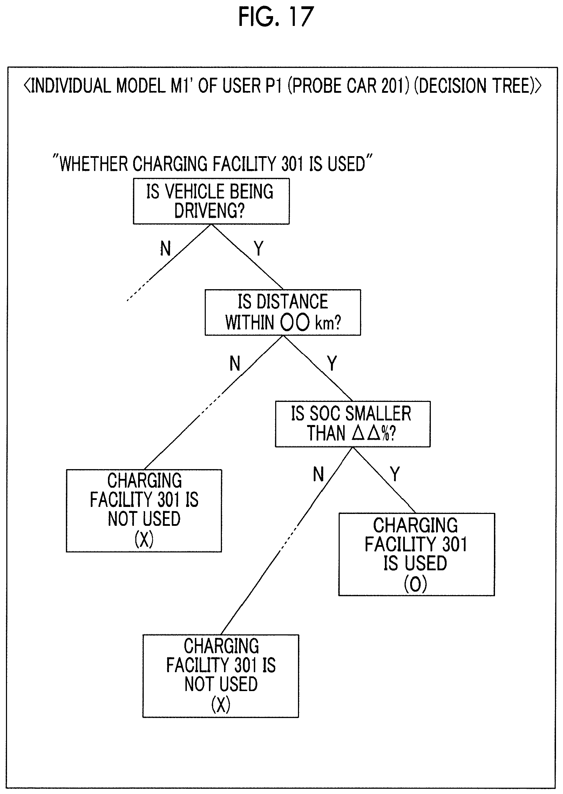

Fig. 17 is a diagram illustrating a function of an individual model acquisition unit according to the modification example of the first embodiment.

The individual model acquisition unit 112 according to the first embodiment derives a bundle of functions of Expressions (1), (2), or the like based on the vehicle probe data D1 accumulated in the past, with respect to correlations between the factor record data D10 (factors $x_1$, $x_2$, and so on) and the usage rate record data D20 (responses $y_1$, $y_2$, and so on), to construct individual models.

As a modification example thereof, for example, the individual model acquisition unit 112 may generate individual models M1', M2', and so on of the users P1, P2, and so on based on decision tree learning. For example, as shown in Fig. 17, the model construction unit 112c constructs an individual model M1' (decision tree model) for deriving a predicted value of a usage rate of the user P1 with respect to the charging facility 301 in each time period based on the factor record data D10 and the usage rate record data D20.

For example, in a decision tree model shown in Fig. 17, a rate at which the user P1 leads to "The charging facility 301 is used." and a rate at which the user P1 leads to "The charging facility 301 is not used." are calculated through paths indicating whether conditions such as "Is a vehicle being operated?", "Is a distance within OO km?", "Is an SOC smaller than ΔΔ%?", and the like are satisfied at a current time point with respect to a question "Is the charging facility 301 used?", to thereby derive a predicted value of a usage rate. In addition, a condition of "Does the condition correspond to fast charging?", "Can an additional service be used?", or the like may be reflected.

In this way, the decision-making results (responses $y_1$, $y_2$, and so on) derived according to whether or not the plural conditions (corresponding to the factors $x_1$, $x_2$, and so on) which are the decision-making factors are satisfied are modeled.

With such a configuration, it is possible to easily write decision-making in charging for each of the users P1, P2, and so on, and to clarify what factor each of the users P1, P2, and so on leads to a decision for charging based on. Thus, it is possible to easily perform adjustment of electricity demand at each of the charging facilities 301, 302, and so on in installation of a new charging facility, in provision of service therein, or the like, for example.

In the above-described electricity supply system 1, a configuration in which usage rates according to time periods are predicted as electricity demand at each of the charging facilities 301, 302, and so on is described, but other embodiments are not limited to this configuration. For example, in an electricity supply system according to another embodiment, an amount of supplied electrical energy [kW] according to time periods at the charging facilities 301, 302, and so on may be used as prediction target information. Specifically, the electricity demand information extraction unit 112b of the individual model acquisition unit 112 may select record data (electricity supply record data) of "the amount of supplied electrical energy" at each of the charging facilities 301, 302, and so on with respect to the responses $y_1$, $y_2$, and so on which are prediction targets, to thereby acquire electricity supply prediction data which is a prediction result of the amount of supplied electrical energy.

<Second embodiment>

In the first embodiment, a configuration in which "prediction based on an individual behavior trend" (step S02 in Fig. 12) performed by the demand prediction computation unit 113 is performed using the individual models M1, M2, and so on in which a decision-making feature in charging for each user is reflected, generated based on the vehicle probe data D1 which is record data acquired in advance is described.

On the other hand, in the second embodiment, "prediction based on an individual behavior trend" is performed by a method of distributing demand using distances to the charging facilities 301, 302, and so on where individuals stop by.

(Function of demand prediction computation unit)

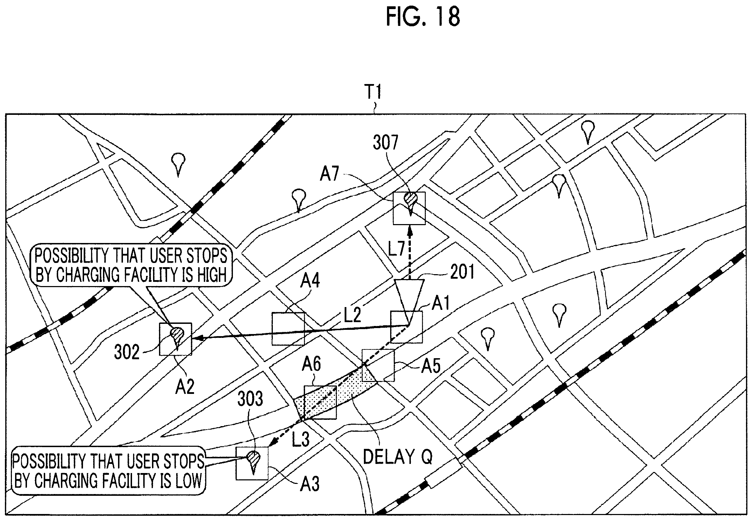

Fig. 18 is a diagram illustrating a function of the demand prediction computation unit according to the second embodiment.

The demand prediction computation unit 113 according to this embodiment performs "prediction based on a group behavior trend" by the same method as in the first embodiment (or its modification example). Specifically, the demand prediction computation unit 113 acquires vehicle density distribution prediction data D30F calculated by the area feature value prediction unit 114 (step S01 in Fig. 12). The demand prediction computation unit 113 may determine a rate at which the user P1 is present in each of the divided areas A1, A2, and so on from the vehicle density distribution prediction data D30F acquired in step S01.

The demand prediction computation unit 113 performs "prediction based on an individual behavior trend" using the vehicle density distribution prediction data D30F as an input.

A case where the user P1 (probe car 201) is present in the divided area A1 in the city T1 will be described as an example with reference to Fig. 18. The demand prediction computation unit 113 predicts an individual behavior trend of the user P1 in the divided area A1 based on an individual model acquired by the individual model acquisition unit 112.

Here, the individual model acquisition unit 112 acquires individual models in which only decision-making features suitable for all users (individuals) are reflected. Specifically, for example, the individual model acquisition unit 112 acquires individual models in which individual decision-making features indicating that a rate at which a user stops by each of the charging facilities 301, 302, and so on becomes higher as a distance from a current position (a "generalized distance" which will be described later) becomes closer.

First, the demand prediction computation unit 113 calculates the distance from the current position of the user P1 to each of the charging facilities 301, 302, and so on using the map data D4 or the like. Here, the distance to each of the charging facilities 301, 302, and so on calculated by the demand prediction computation unit 113 refers to a "generalized distance" in which the degree of delay or congestion, or the like which is present on a traveling path is reflected. Specifically, the demand prediction computation unit 113 calculates a generalized distance L2 from the current position (divided area A1) to the divided area A2 where a certain charging facility 302 is present, a generalized distance L3 from the current position (divided area A1) to the divided area A3 where another charging facility 303 is present, and so on.

For example, as shown in Fig. 18, since delay Q occurs in the middle of a traveling path from the divided area A1 to the divided area A3, a divided area A5 having a low vehicle density and a divided area A6 having a high vehicle density appear. In this case, the demand prediction computation unit 113 specifies a divided area (divided area A6) where a vehicle density is larger than a predetermined threshold value, and multiplies the length of a traveling path that passes through the divided area A6 by a predetermined delay coefficient J (J>1), to thereby calculate the generalized distance L3.

On the other hand, no delay occurs in the middle of a traveling path from the divided area A1 to the divided area A2 (in the divided area A4 or the like). Accordingly, the demand prediction computation unit 113 sets an actual distance from the divided area A1 to the divided area A2 as the generalized distance L2.

Thus, in a case where delay occurs in a part of a traveling path, the demand prediction computation unit 113 calculates a generalized distance which is longer than an actual distance. The demand prediction computation unit 113 calculates the generalized distances L1, L2, and so on where the presence or absence of delay is reflected according to the charging facilities 301, 302, and so on.

The demand prediction computation unit 113 according to this embodiment inputs the calculated generalized distances L1, L2, and so on to the above-described individual model M to calculate predicted values of rates (usage rates) at which the user P1 stops by the respective charging facilities 301, 302, and so on. For example, the individual model M is a model obtained by associating the generalized distances L1, L2, and so on with the rates at which the user stops by the respective charging facilities 301, 302, and so on using a predetermined function having a negative correlation. Thus, the demand prediction computation unit 113 can calculate predicted values of usage rates of the charging facilities 301, 302, and so on while reflecting an individual behavior trend of the user P1 indicating that the user preferentially stops by a charging facility among the charging facilities 301, 302, and so on having a smaller one of the generalized distances L1, L2, and so on.

The predicted values of the usage rates of the respective charging facilities 301, 302, and so on calculated as described above are predicted values of usage rates in a case where the user P1 belongs to the area A1. The demand prediction computation unit 113 also performs the same processes in a case where the user P1 is present in the other divided areas A1, A2, and so on. The demand prediction computation unit 113 performs weighting with respect to predicted values of plural usage rates calculated in the above processes using rates where the user P1 is present in the divided areas A1, A2, and so on using the vehicle density distribution prediction data D30F as an input, and sums up the results.

(Effects)

As described above, the demand prediction computation unit 113 according to this embodiment performs "prediction based on an individual behavior trend" by calculating predicted values of usage rates of a user based on "generalized distances" with respect to the respective charging facilities 301, 302, and so on. Thus, it is possible to simplify the process of "prediction based on an individual behavior trend", and to reduce efforts for acquiring the vehicle probe data D1 and generating the individual models M1, M2, and so on.

In this embodiment, prediction of a traffic flow (traffic flow prediction data) calculated using a traffic flow simulator (see the modification example of the first embodiment), in addition to the vehicle density distribution prediction data D30F, may be used. Here, the traffic flow prediction data represents information indicating distribution of a traffic flow (traveling direction) in each road network of the city T1. In this case, the demand prediction computation unit 113 calculates a generalized distance with respect to each of the charging facilities 301, 302, and so on while performing weighting based on a vehicle traveling direction. Specifically, for example, it is assumed that the user P1 (probe car 201) is a vehicle which travels from the divided area A1 toward the divided area A3. In this case, since the charging facility 303 is present in a traveling direction, the demand prediction computation unit 113 calculates a generalized distance L3 without performing weighting based on the traveling direction. On the other hand, with respect to the user P1 who moves from the divided area A1 toward the divided area A3, a charging facility 307 which is present in a divided area A7 is located in a direction opposite to the traveling direction. Accordingly, the demand prediction computation unit 113 calculates a generalized distance L7 by multiplying an actual distance to the divided area A7 by a direction coefficient H (H>1).

Thus, it is possible to reflect a vehicle traveling direction in an individual behavior trend, and thus, it is possible to perform electricity demand prediction with high accuracy.

Further, the area feature value prediction unit 114 may further acquire predicted values of the degrees of congestion (waiting time) based on observation results (record values) of the degrees of congestion at the respective charging facilities 301, 302, and so on. In this case, the demand prediction computation unit 113 may calculate the generalized distances L1, L2, and so on in consideration of the predicted values of the "degrees of congestion" at the respective charging facilities 301, 302, and so on thereto, in addition to the "presence or absence of delay". Thus, it is possible to predict individual behavior trends in which congestion situations at the charging facilities 301, 302, and so on are reflected.

Furthermore, the demand prediction computation unit 113 may calculate predicted values of usage rates of the charging facilities 301, 302, and so on based on actual distances (distances in an actual space) instead of the above-described "generalized distances", as "distances" between a current position of a vehicle and the charging facilities 301, 302, and so on. Thus, it is possible to simplify the prediction process of the demand prediction computation unit 113.

In all of the electricity supply systems according to the above-described embodiments, the electricity supply management device 400 makes a distribution plan so that necessary minimum electricity suitable for a prediction result can be supplied based on and in reflection of a prediction result of the electricity-demand prediction device 100, to achieve an efficient operation. However, an electricity supply system according to another embodiment may be configured to include a request notification device that notifies each user of an electric car which belongs to the city T1 of a mail for refraining from using a predetermined facility at a specific time period according to the received prediction result, and for promoting usage of a predetermined charging facility at another specific time period as necessary. For example, in a case where the demand notification device receives a prediction that electricity demand for the charging facility 301 noticeably increases in a time periodof 6 p.m. on a specific day, the demand notification device transmits a mail for requesting users having a high usage rate at the charging facility 301 to refrain from using the charging facility 301 in the time period and to use the charging facility 301 at another time period at which electricity demand is predicted to be low. Thus, each user can follow the request, to thereby make it possible to conveniently perform peak cut (peak shift) in electricity demand.

Further, in this case, individual models may be constructed in consideration of how much influence the presence or absence of reception of the above-described usage refrain notification mail has as a decision-making factor in charging for each of the users P1, P2, and so on. Thus, it is possible to effectively select a delivery destination of the usage refrain notification mail.

A program for realizing the functions of the electricity-demand prediction device 100 in the above-described embodiments may be recorded on a computer-readable recording medium, and a computer system may read the program recorded on the recording medium for execution, to perform the processes. Here, the "computer system" is configured to include hardware such as an OS or peripheral devices. In addition, the "computer system" is configured to include a WWW system including a home page provision environment (or a display environment). Furthermore, the "computer-readable recording medium" refers to a portable medium such as a flexible disc, a magneto-optical disc, a ROM, or a CD-ROM, or a storage medium such as a hard disk built in a computer system. Here, the "computer-readable recording medium" may include a recording medium that retains a program for a predetermined time, such as a volatile memory (RAM) in a computer system which serves as a server or a client in a case where the program is transmitted through a network such as the Internet or a communication line such as a telephone line.

Further, the program may be transmitted to another computer system from the computer system in which the program is stored in a storage device or the like through a transmission medium, or through transmission waves in the transmission medium. Here, the "transmission medium" that transmits the program refers to a medium that has a function of transmitting information, such as a network (communication network) such as the Internet or a communication line (communication network) such as a telephone line. In addition, the program may realize a part of the above-described functions. Furthermore, the program may be a so-called differential file (differential program) capable of realizing the above-described functions in combination with a program stored in advance in a computer system.

Hereinbefore, several embodiments of the invention have been described, but the embodiments are only examples, and do not limit the scope of the invention.

Industrial Applicability

According to the above-described embodiments, it is possible to perform electricity demand prediction with high accuracy based on limited record data.

Reference Signs List

| 1 | Electricity supply system |
|---|---|
| 100 | Electricity-demand prediction device |
| 101 | Data reception unit |
| 102 | Data output unit |
| 110 | CPU |
| 111 | Data accumulation unit |
| 112 | Individual model acquisition unit |
| 112a | Factor information extraction unit |
| 112b | Electricity demand information extraction unit |
| 112c | Model construction unit |
| 113 | Demand prediction computation unit |
| 114 | Area feature value prediction unit |
| 120 | Probe data storage unit |
| 121 | Individual model storage unit |
| 123 | Map and calendar data storage unit |
| 201, 202, ... | Probe car |
| 301, 302, ... | Charging facility |
| 400 | Electricity supply management device |

## Claims

1.  An electricity-demand prediction device (100) comprising:

    an area feature value prediction unit (114) that is configured to receive an input of measurement data relating to a vehicle (201, 202, 203, 204) and predict, according to divided areas (A1, A2) which are divided into plural pieces, an area feature value indicating a feature of a group behavior trend of all the vehicles (201, 202, 203, 204) that are present in a divided area (A1);
    an individual model acquisition unit (112) that is configured to acquire, using the area feature value as an input and using electricity demand for a specific vehicle (201) at a specific charging facility (301) as an output, an individual model (M1) of each specific vehicle (201); and
    a demand prediction computation unit (113) that is configured to input the predicted area feature value to the individual model (M1) to calculate a predicted value of electricity demand for the specific vehicle (201) corresponding to the individual model (M1) at the specific charging facility (301).

2.  The electricity-demand prediction device (100) according to claim 1,
    wherein the area feature value prediction unit (114) includes at least one of a vehicle density in the divided area (A1), an average speed of all the vehicles in the divided area (A1), or an average charging rate of batteries of all the vehicles that are present in the divided area, as the area feature value.

3.  The electricity-demand prediction device (100) according to claim 1 or 2,
    wherein the individual model acquisition unit (114) is configured to generate an individual model (M1) indicating a correlation between a record value of factor information indicating a decision-making factor for charging of a specific vehicle (201) at a specific charging facility (301) and a record value indicating electricity demand for the specific vehicle (201) at the specific charging facility (301), with respect to the specific vehicle (201), based on measurement data relating to the vehicle (201).

4.  The electricity-demand prediction device (100) according to claim 1 or 2,
    wherein the individual model acquisition unit (114) is configured to acquire an individual model (M1) indicating a correlation between a distance between a current position of the specific vehicle (201) and the specific charging facility (301) and electricity demand at the specific charging facility (301).

5. An electricity supply system (1) comprising:

the electricity-demand prediction device (100) according to any one of claims 1 to 4; and
an electricity supply management device (400) that is configured to adjust an electricity supply for each charging facility (301, 302, 303, 304) according to a prediction result of the electricity-demand prediction device (100).

6. An electricity-demand prediction method comprising the steps of:

receiving an input of measurement data relating to a vehicle (201, 202, 203, 204) and predicting, according to divided areas (A1, A2) which are divided into plural pieces, an area feature value indicating a feature of a group behavior trend of all the vehicles (201, 202, 203, 204) that are present in a divided area (A1);
acquiring, using the area feature value as an input and using electricity demand for a specific vehicle (201) at a specific charging facility (301) as an output, an individual model (M1) of each specific vehicle (201); and
inputting the predicted area feature value to the individual model (M1) to calculate a predicted value of electricity demand for the specific vehicle (201) corresponding to the individual model (M1) at the specific charging facility (301).

7. A program that causes a computer of an electricity-demand prediction device (100) to function as:

a unit (114) for receiving an input of measurement data relating to a vehicle (201, 202, 203, 204) and predicting, according to divided areas (A1, A2) which are divided into plural pieces, an area feature value indicating a feature of a group behavior trend of all the vehicles (201, 202, 203, 204) that are present in a divided area (A1);
a unit (112) for acquiring, using the area feature value as an input and using electricity demand for a specific vehicle (201) at a specific charging facility (301) as an output, an individual model (M1) of each specific vehicle (201); and
a unit (113) for inputting the predicted area feature value to the individual model (M1) to calculate a predicted value of electricity demand for the specific vehicle (201) corresponding to the individual model (M1) at the specific charging facility (301).

**Patentansprüche**

1. Elektrizitätsnachfrage-Vorhersagevorrichtung (100), aufweisend:

eine Flächenmerkmalswert-Vorhersageeinheit (114), die konfiguriert ist, um eine Eingabe von Messdaten bezogen auf ein Fahrzeug (201, 202, 203, 204) zu empfangen, und gemäß aufgeteilten Flächen (A1, A2), welche in eine Vielzahl von Teilen aufgeteilt sind, einen Flächenmerkmalswert vorherzusagen, der ein Merkmal eines Gruppenverhaltenstrends von allen Fahrzeugen (201, 202, 203, 204) anzeigt, die in einer aufgeteilten Fläche (A1) vorliegen;
eine Individuelles-Modell-Akquirierungseinheit (112), die konfiguriert ist, um unter Verwendung des Flächenmerkmalswerts als eine Eingabe und unter Verwendung einer Elektrizitätsnachfrage für ein spezifisches Fahrzeug (201) an einer spezifischen Ladeeinrichtung (301) als eine Ausgabe ein individuelles Model (M1) von jedem spezifischen Fahrzeug (201) zu akquirieren; und
eine Nachfrage-Vorhersage-Berechnungseinheit (113), die konfiguriert ist, um den vorhergesagten Flächenmerkmalswert in das individuelle Modell (M1) einzugeben, um einen vorhergesagten Wert einer Elektrizitätsnachfrage für das spezifische Fahrzeug (201) korrespondierend zu dem individuellen Modell (M1) an der spezifischen Ladeeinrichtung (301) zu berechnen.

2. Elektrizitätsnachfrage-Vorhersagevorrichtung (100) nach Anspruch 1,
wobei die Flächenmerkmalswert-Vorhersageeinheit (114) zumindest eines von einer Fahrzeugdichte in der aufgeteilten Fläche (A1), einer Durchschnittsgeschwindigkeit von allen Fahrzeugen in der aufgeteilten Fläche (A1) oder einer Durchschnittsladerate von Batterien von allen Fahrzeugen, die in der aufgeteilten Fläche vorliegen, als den Flächenmerkmalswert umfasst.

3. Elektrizitätsnachfrage-Vorhersagevorrichtung (100) nach Anspruch 1 oder 2,

wobei die Individuelles-Modell-Akquirierungseinheit (114) konfiguriert ist, um ein individuelles Modell (M1), das eine Korrelation zwischen einem Aufzeichnungswert von Faktorinformationen, die einen Entscheidungsfindungsfaktor zum Laden eines spezifischen Fahrzeugs (201) an einer spezifischen Ladeeinrichtung (301) anzeigen, und einen Aufzeichnungswert, der eine Elektrizitätsnachfrage für das spezifische Fahrzeug (201) an der spezifischen Ladeeinrichtung (301) mit Bezug auf das spezifische Fahrzeug (201) anzeigt, basierend auf Messdaten bezogen auf das Fahrzeug (201) zu erzeugen.

4. Elektrizitätsnachfrage-Vorhersagevorrichtung (100) nach Anspruch 1 oder 2,
wobei die Individuelles-Modell-Akquirierungseinheit (114) konfiguriert ist, um ein individuelles Modell (M1), das eine Korrelation zwischen einer Entfernung zwischen einer gegenwärtigen Position des spezifischen Fahrzeugs (201) und der spezifischen Ladeeinrichtung (301) und einer Elektrizitätsnachfrage an der spezifischen Ladeeinrichtung (301) anzeigt, zu akquirieren.

5. Elektrizitätsversorgungssystem (1), aufweisend:

die Elektrizitätsnachfrage-Vorhersagevorrichtung (100) nach einem der Ansprüche 1 bis 4; und
eine Elektrizitätsversorgungs-Verwaltungsvorrichtung (400), die konfiguriert ist, um eine Elektrizitätsversorgung für jede Ladeeinrichtung (301, 302, 303, 304) gemäß einem Vorhersageergebnis der Elektrizitätsnachfrage-Vohersagevorrichtung (100) einzustellen.

6. Elektrizitätsnachfrage-Vorhersageverfahren mit den folgenden Schritten:

Empfangen einer Eingabe von Messdaten bezogen auf ein Fahrzeug (201, 202, 203, 204), und Vorhersagen gemäß aufgeteilten Flächen (A1, A2), welche in eine Vielzahl von Teilen aufgeteilt sind, eines Flächenmerkmalswerts, der ein Merkmal eines Gruppenverhaltenstrends von allen Fahrzeugen (201, 202, 203, 204), die in einer aufgeteilten Fläche (A1) vorliegen, anzeigt;
Akquirieren, unter Verwendung des Flächenmerkmalswerts als eine Eingabe und unter Verwendung einer Elektrizitätsnachfrage für ein spezifisches Fahrzeug (201) an einer spezifischen Ladeeinrichtung (301) als eine Ausgabe, eines individuellen Modells (M1) von jedem spezifischen Fahrzeug (201); und
Eingeben des vorhergesagten Flächenmerkmalswerts in das individuelle Modell (M1), um einen vorhergesagten Wert einer Elektrizitätsnachfrage für das spezifische Fahrzeug (201) korrespondierend zu dem individuellen Modell (M1) an der spezifischen Ladeeinrichtung (301) zu berechnen.

7. Programm, welches bewirkt, dass ein Computer einer Elektrizitätsnachfrage-Vorhersagevorrichtung (100) als folgendes fungiert:

eine Einheit (114) zum Empfangen einer Eingabe von Messdaten bezogen auf ein Fahrzeug (201, 202, 203, 204), und Vorhersagen gemäß aufgeteilten Flächen (A1, A2), welche in eine Vielzahl von Teilen aufgeteilt sind, eines Flächenmerkmalswerts, der ein Merkmal eines Gruppenverhaltenstrends von allen Fahrzeugen (201, 202, 203, 204) anzeigt, die in einer aufgeteilten Fläche (A1) vorliegen;
eine Einheit (112) zum Akquirieren, unter Verwendung des Flächenmerkmalswerts als eine Eingabe und unter Verwendung einer Elektrizitätsnachfrage für ein spezifisches Fahrzeug (201) an einer spezifischen Ladeeinrichtung (301) als eine Ausgabe, eines individuellen Modells (M1) von jedem spezifischen Fahrzeug (201); und
eine Einheit (113) zum Eingeben des vorhergesagten Flächenmerkmalswerts in das individuelle Modell (M1), um einen vorhergesagten Wert einer Elektrizitätsnachfrage für das spezifische Fahrzeug (201) korrespondierend zu dem individuellen Modell (M1) an der spezifischen Ladeeinrichtung (301) zu berechnen.

**Revendications**

1. Dispositif de prédiction de demande d'électricité (100) comprenant :

une unité de prédiction de valeur de particularité de zone (114) configurée pour recevoir une entrée de données de mesure relatives à un véhicule (201, 202, 203, 204) et prédire, selon des zones divisées (A1, A2) qui sont divisées en plusieurs pièces, une valeur de particularité de zone indiquant une particularité d'une tendance de comportement de groupe de tous les véhicules (201, 202, 203, 204) présents dans une zone divisée (A1) ;
une unité d'acquisition de modèle individuel (112) configurée pour acquérir, à l'aide de la valeur de particularité de zone en tant qu'entrée et à l'aide d'une demande d'électricité pour un véhicule spécifique (201) au niveau d'une installation de recharge spécifique (301) en tant que sortie, un modèle individuel (M1) de chaque véhicule spécifique (201); et

une unité de calcul de prédiction de demande (113) configurée pour entrer la valeur de particularité de zone prédite dans le modèle individuel (M1) pour calculer une valeur prédite de demande d'électricité pour le véhicule spécifique (201) correspondant au modèle individuel (M1) au niveau de l'installation de recharge spécifique (301).

2. Dispositif de prédiction de demande d'électricité (100) selon la revendication 1,
dans lequel l'unité de prédiction de valeur de particularité de zone (114) comporte au moins l'un parmi une densité de véhicules dans la zone divisée (A1), une vitesse moyenne de tous les véhicules dans la zone divisée (A1), ou un taux de recharge moyen de batteries de tous les véhicules qui sont présents dans la zone divisée, en tant que valeur de particularité de zone.

3. Dispositif de prédiction de demande d'électricité (100) selon la revendication 1 ou 2,
dans lequel l'unité d'acquisition de modèle individuel (114) est configurée pour générer un modèle individuel (M1) indiquant une corrélation entre une valeur d'enregistrement d'informations de facteur indiquant un facteur de prise de décision pour recharger un véhicule spécifique (201) au niveau d'une installation de recharge spécifique (301) et une valeur d'enregistrement indiquant une demande d'électricité pour le véhicule spécifique (201) au niveau de l'installation de recharge spécifique (301), par rapport au véhicule spécifique (201), d'après des données de mesure relatives au véhicule (201).

4. Dispositif de prédiction de demande d'électricité (100) selon la revendication 1 ou 2,
dans lequel l'unité d'acquisition de modèle individuel (114) est configurée pour acquérir un modèle individuel (M1) indiquant une corrélation entre une distance entre une position actuelle du véhicule spécifique (201) et l'installation de recharge spécifique (301) et une demande d'électricité au niveau de l'installation de recharge spécifique (301) .

5. Système d'alimentation en électricité (1) comprenant :

le dispositif de prédiction de demande d'électricité (100) selon l'une quelconque des revendications 1 à 4 ; et
un dispositif de gestion d'alimentation en électricité (400) configuré pour régler une alimentation en électricité pour chaque installation de recharge (301, 302, 303, 304) selon un résultat de prédiction du dispositif de prédiction de demande d'électricité (100).

6. Procédé de prédiction de demande d'électricité comprenant les étapes de :

recevoir une entrée de données de mesure relatives à un véhicule (201, 202, 203, 204) et prédire, selon des zones divisées (A1, A2) qui sont divisées en plusieurs pièces, une valeur de particularité de zone indiquant une particularité d'une tendance de comportement de groupe de tous les véhicules (201, 202, 203, 204) présents dans une zone divisée (A1) ;
acquérir, à l'aide de la valeur de particularité de zone en tant qu'entrée et à l'aide d'une demande d'électricité pour un véhicule spécifique (201) au niveau d'une installation de recharge spécifique (301) en tant que sortie, un modèle individuel (M1) de chaque véhicule spécifique (201); et
entrer la valeur de particularité de zone prédite dans le modèle individuel (M1) pour calculer une valeur prédite de demande d'électricité pour le véhicule spécifique (201) correspondant au modèle individuel (M1) au niveau de l'installation de recharge spécifique (301).

7. Programme qui amène un ordinateur d'un dispositif de prédiction de demande d'électricité (100) à fonctionner comme :

une unité (114) de réception d'une entrée de données de mesure relatives à un véhicule (201, 202, 203, 204) et de prédiction, selon des zones divisées (A1, A2) qui sont divisées en plusieurs pièces, d'une valeur de particularité de zone indiquant une particularité d'une tendance de comportement de groupe de tous les véhicules (201, 202, 203, 204) présents dans une zone divisée (A1) ;
une unité (112) d'acquisition, à l'aide de la valeur de particularité de zone en tant qu'entrée et à l'aide d'une demande d'électricité pour un véhicule spécifique (201) au niveau d'une installation de recharge spécifique (301) en tant que sortie, d'un modèle individuel (M1) de chaque véhicule (201) spécifique ; et
une unité (113) d'entrée de la valeur de particularité de zone prédite dans le modèle individuel (M1) pour calculer une valeur prédite de demande d'électricité pour le véhicule spécifique (201) correspondant au modèle individuel (M1) au niveau de l'installation de recharge spécifique (301).

# FIG. 1

EP 3 076 512 B1

# FIG. 2

PROBE CAR ~201, 202, …

VEHICLE PROBE DATA D1

100

110

DATA RECEPTION UNIT ~101

VEHICLE PROBE DATA D1

DATA ACCUMULATION UNIT ~111

VEHICLE PROBE DATA D1

120 — PROBE DATA STORAGE UNIT

AREA FEATURE VALUE PREDICTION UNIT ~114

AREA FEATURE VALUE PREDICTION DATA D3

INDIVIDUAL MODEL ACQUISITION UNIT ~112

112a 112b 112c

121 — INDIVIDUAL MODEL STORAGE UNIT

123 — MAP AND CALENDAR DATA STORAGE UNIT

DEMAND PREDICTION COMPUTATION UNIT ~113

USAGE RATE PREDICTION DATA D20F

DATA OUTPUT UNIT ~102

ELECTRICITY SUPPLY MANAGEMENT DEVICE ~400

FIG. 3

<VEHICLE PROBE DATA D1>

| VEHICLE ID | DATE | TIME | OPERATING STATE | VEHICLE POSITION | SOC |
|---|---|---|---|---|---|
| ID : XXXXXXXXXX | 01/xx/2012(MON) | 10:00 | ON | LATITUDE○○ : LONGITUDE×× | 42% |
| ID : XXXXXXXXXX | 01/xx/2012(MON) | 10:30 | ON | LATITUDE○○ : LONGITUDE×× | 40% |
| ID : XXXXXXXXXX | 01/xx/2012(MON) | 11:00 | ON | LATITUDE○○ : LONGITUDE×× | 39% |
| ID : XXXXXXXXXX | 01/xx/2012(MON) | 11:30 | OFF | LATITUDE○○ : LONGITUDE×× | 39% |
| ⋮ | ⋮ | ⋮ | ⋮ | ⋮ | ⋮ |

EP 3 076 512 B1

# FIG. 4

⟨TIME PERIOD ACTIVITY AREA DATA D12⟩

USER P1 (PROBE CAR 201)

PRESENCE RATE OF USER P1 AT SPECIFIC TIME PERIOD

DIVIDED AREAS A1, A2, ...

USER P2 (PROBE CAR 202)

USER P3 (PROBE CAR 203)

USER P4 (PROBE CAR 204)

# FIG. 5

⟨TIME PERIOD SOC DATA D13⟩

USER P1 (PROBE CAR 201)

USER P2 (PROBE CAR 202)

USER P3 (PROBE CAR 203)

USER P4 (PROBE CAR 204)

EP 3 076 512 B1

FIG. 6

## FIG. 7

VEHICLE PROBE DATA D1 ACQUIRED
FROM USER P1 (PROBE CAR 201)
↓ EXTRACTION ↓

$y_1, y_2, y_3, \cdots$: USAGE RATE RECORD DATA
D20 OF RESPECTIVE CHARGING
FACILITIES 301, 302, 303, $\cdots$

$x_1, x_2, \cdots$: FACTOR RECORD DATA D10
(TIME PERIOD ACTIVITY AREA DATA D12
AND TIME PERIOD SOC DATA D13)

DECISION-MAKING MODEL M1 OF USER P1 (PROBE CAR 201)

$\Rightarrow$ $y_1 = a_{11}x_1 + b_{11}x_2 + c_{11}x_3 + d_{11}x_4 + \cdots$
$(y_1 = f_{A1P1}(x_1, x_2, x_3, x_4 \cdots))$

$\Rightarrow$ $y_2 = a_{12}x_1 + b_{12}x_2 + c_{12}x_3 + d_{12}x_4 + \cdots$
$(y_2 = f_{A2P1}(x_1, x_2, x_3, x_4 \cdots))$

$\Rightarrow$ $y_3 = a_{13}x_1 + b_{13}x_2 + c_{13}x_3 + d_{13}x_4 + \cdots$

$\Rightarrow$ $y_4 = a_{14}x_1 + b_{14}x_2 + c_{14}x_3 + d_{14}x_4 + \cdots$

$\vdots$

(plot axes: $y_1, y_2, y_3 \cdots$ vs $x_1, x_2, x_3 \cdots$)

---

VEHICLE PROBE DATA D1 ACQUIRED
FROM USER P2 (PROBE CAR 202)

$y$ │ $x$

DECISION-MAKING MODEL M2
OF USER P2 (PROBE CAR 202)

$y_1 = a_{21}x_1 + b_{21}x_2 + c_{21}x_3 + d_{21}x_4 + \cdots$
$\vdots$

---

VEHICLE PROBE DATA D1 ACQUIRED
FROM USER P3 (PROBE CAR 203)

$y$ │ $x$

DECISION-MAKING MODEL M3
OF USER P3 (PROBE CAR 203)

$y_1 = a_{31}x_1 + b_{31}x_2 + c_{31}x_3 + d_{31}x_4 + \cdots$
$\vdots$

---

VEHICLE PROBE DATA D1 ACQUIRED
FROM USER P4 (PROBE CAR 204)

$y$ │ $x$

DECISION-MAKING MODEL M4
OF USER P4 (PROBE CAR 204)

$y_1 = a_{41}x_1 + b_{41}x_2 + c_{41}x_3 + d_{41}x_4 + \cdots$
$\vdots$

$\vdots$ $\vdots$

EP 3 076 512 B1

# FIG. 8

EP 3 076 512 B1

VECHICLE POSITION ($x_1$) $\longrightarrow$

SOC($x_2$) $\longrightarrow$

$\vdots$

M1

$y_1 = f_{A1P1}(x_1,\ x_2 \cdots)$

$y_2 = f_{A2P1}(x_1, x_2 \cdots)$

$\vdots$

$\longrightarrow$ $y_1,\ y_2 \cdots$: USAGE RATES OF CHARGING
FACILITIES 301, 302 $\cdots$

# FIG. 9

MAP DATA D4       A1, A2,···

CALENDAR DATA D5

| 1 | 2 | 3 | 4 | 5 | 6 | 7 |
|---|---|---|---|---|---|---|
| 8 | 9 | 10 | 11 | 12 | 13 | 14 |
| 15 | 16 | 17 | 18 | 19 | 20 | 21 |
| 22 | 23 | 24 | 25 | 26 | 27 | 28 |
| 29 | 30 | 31 | | | | |

VEHICLE PROBE DATA D1
(PROBE CARS 201, 202, AND SO ON)

114

AREA FEATURE VALUE PREDICTION UNIT

VEHICLE DENSITY DISTRIBUTION PREDICTION DATA D30F, AVERAGE SOC DISTRIBUTION PREDICTION DATA D31F

EP 3 076 512 B1

# FIG. 10

⟨VEHICLE DENSITY DISTRIBUTION RECORD DATA D30⟩
(AVERAGE SOC DISTRIBUTION RECORD DATA D31)

A1, A2,···

TIME

⟨TEMPORAL CHANGE IN VEHICLE
DENSITY IN SPECIFIC DIVIDED AREA⟩

VEHICLE DENSITY

HOLIDAYS
······
WEEKDAYS

TIME

⟨CALENDAR DATA D5⟩

| 1 | 2 | 3 | 4 | 5 | 6 | 7 |
|---|---|---|---|---|---|---|
| 8 | 9 | 10 | 11 | 12 | 13 | 14 |
| 15 | 16 | 17 | 18 | 19 | 20 | 21 |
| 22 | 23 | 24 | 25 | 26 | 27 | 28 |
| 29 | 30 | 31 | | | | |

EP 3 076 512 B1

FIG. 11

<VEHICLE DENSITY DISTRIBUTION PREDICTION DATA D30F>

(AVERAGE TEMPORAL CHANGE IN VEHICLE DENSITY DISTRIBUTION ON WEEKDAYS) A1, A2,···

(AVERAGE TEMPORAL CHANGE IN VEHICLE DENSITY DISTRIBUTION ON HOLIDAYS OR FESTIVE DAYS) A1, A2,···

TIME
(PER DAY)

TIME
(PER DAY)

EP 3 076 512 B1

FIG. 12

```
         ┌─────────────┐
         │    START    │
         └──────┬──────┘
                │                        ╭─ S01
    ┌───────────▼──────────────────────────────┐
    │ (DERIVE AREA FEATURE VALUE PREDICTION DATA)│
    │ ACQUIRE AREA FEATURE VALUE PREDICTION DATA │
    └───────────┬──────────────────────────────┘
                │                        ╭─ S02
    ┌───────────▼──────────────────────────────┐
    │  INPUT AREA FEATURE VALUE PREDICTION DATA │
    │        TO EACH INDIVIDUAL MODEL           │
    └───────────┬──────────────────────────────┘
                │
         ┌──────▼──────┐
         │     END     │
         └─────────────┘
```

# FIG. 13

〈VEHICLE DENSITY DISTRIBUTION PREDICTION DATA D30F〉

VEHICLE POSITION $(x_1)$

〈AVERAGE SOC DISTRIBUTION PREDICTION DATA D31F〉

$SOC(x_2)$

M1

$y_1 = f_{A1P1}(x_1, x_2 \cdots)$

$y_2 = f_{A2P1}(x_1, x_2 \cdots)$

$y_1, y_2 \cdots$:
USAGE RATES OF CHARGING
FACILITIES 301, 302 …

EP 3 076 512 B1

FIG. 14

# FIG. 15

⟨USAGE RATE PREDICTION DATA D20F⟩

CHARGING FACILITY
301

USAGE RATE [%]

TIME [hr]

CHARGING FACILITY
302

USAGE RATE [%]

TIME [hr]

CHARGING FACILITY
303

USAGE RATE [%]

TIME [hr]

CHARGING FACILITY
304

USAGE RATE [%]

TIME [hr]

.........

# FIG. 16

S012
TIME PERIOD SOC DATA D13
(CURRENT TIME POINT)

S011
⟨VEHICLE DENSITY DISTRIBUTION
PREDICTION DATA D30F⟩

S013
⟨AVERAGE SOC DISTRIBUTION
PREDICTION DATA D31F⟩

S010
MAP DATA D4
CALENDAR DATA D5

TRAFFIC RECORD
DATA D6

EP 3 076 512 B1

# FIG. 17

<INDIVIDUAL MODEL M1' OF USER P1 (PROBE CAR 201) (DECISION TREE)>

"WHETHER CHARGING FACILITY 301 IS USED"

EP 3 076 512 B1

FIG. 18

T1

307

A7

POSSIBILITY THAT USER STOPS
BY CHARGING FACILITY IS HIGH

A4

L7

201

L2

A1

302

A2

A6

A5

303

DELAY Q

L3

POSSIBILITY THAT USER STOPS
BY CHARGING FACILITY IS LOW

A3

**EP 3 076 512 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012113546 A
- EP 2465721 A1
- WO 2013024484 A1
- US 2012083932 A1
- EP 2562514 A1